# EUROPÄISCHE PATENTSCHRIFT

(11) **EP 2 030 491 B1**
(45) Veröffentlichungstag und Bekanntmachung des Hinweises auf die Patenterteilung: **31.08.2011**
(21) Anmeldenummer: 07764352.6
(22) Anmeldetag: 04.06.2007
(51) Int. Cl.: H01K 1/00, H03K 17/96

(54) **TEXTILSCHICHT-ANORDNUNG, TEXTILSCHICHT-ARRAY UND VERFAHREN ZUM HERSTELLEN EINER TEXTILSCHICHT-ANORDNUNG**
TEXTILE LAYER ARRANGEMENT, TEXTILE LAYER ARRAY AND METHOD FOR PRODUCING A TEXTILE LAYER ARRANGEMENT
DISPOSITIF DE COUCHES TEXTILES, MATRICE DE COUCHES TEXTILES ET PROCÉDÉ DE FABRICATION D'UN DISPOSITIF DE COUCHES TEXTILES

(30) Priorität: 12.06.2006 DE 102006027213
(43) Veröffentlichungstag der Anmeldung: 04.03.2009
(73) Patentinhaber: Future-Shape GmbH, 85635 Höhenkirchen-Siegertsbrunn (DE)
(72) Erfinder: LAUTERBACH, Christl, 85635 Höhenkirchen-Siegertsbrunn (DE); STEINHAGE, Axel, 85614 Kirchseeon (DE)
(74) Vertreter: Viering, Jentschura & Partner
(86) Internationale Anmeldenummer: PCT/DE2007/001006
(87) Internationale Veröffentlichungsnummer: WO 2007/143966

(56) Entgegenhaltungen:
- DE-A1- 10 307 505
- DE-A1- 10 307 505
- US-A- 4 664 158
- US-A- 5 749 365
- US-A1- 2003 211 797
- US-A1- 2004 259 391
- US-A1- 2005 029 680
- US-A1- 2005 069 695

## Beschreibung

Die Erfindung betrifft eine Textilschicht-Anordnung, ein Textilschicht-Array und ein Verfahren zum Herstellen einer Textilschicht-Anordnung.

Seit einigen Jahren gibt es Bestrebungen seitens Forschung und Entwicklung, Technologie so zu gestalten, dass die eigentlichen Geräte in der Umgebung des Menschen in den Hintergrund treten und nur die Funktion der Geräte für einen Benutzer sichtbar wird. Ausprägungen solcher mit dem Begriff "Umgebungsintelligenz" (Ambient Intelligence) bezeichneten Entwicklungen sind beispielsweise Stereoanlagen, die keine Bedienpanele mehr enthalten sondern auf Gestik oder Sprache des Benutzers reagieren. Im Extremfall muss der Benutzer eine Melodie nur noch vor sich hin summen, um diese abspielen zu lassen. Von solchen Visionen geht eine große Faszination aus. Andererseits lässt sich das prinzip von Ambient Intelligence aber auch in eher konventionellen Szenarien sinnvoll anwenden.

Die beiden Unternehmen "Vorwerk Teppichwerke" und "Infineon Technologies AG" haben auf der Fachmesse "Orgatec 2004" einen ersten Funktionsprototypen eines interaktiven Teppichbodens (sogenannter "denkender Teppich" bzw. "Thinking Carpet") mit eingestickten Sensorfeldem zur Personendetektion vorgestellt, siehe [1]. Bei dem vorgestellten Teppichboden sind die Sensoren mit Kupferlitze mäanderförmig gestickt. Die Mikroelektronikmodule sind unter Verwendung konventioneller Bauelemente auf einer Platine (Printed Circuit Board, PCB) in das Textil integriert. Die Module sind innerhalb des gewebten Textils untereinander durch leitfähige Fasern zum Datenaustausch verbunden. Sensorsignale werden über eine sich selbst organisierende baumförmige Netzwerkarchitektur zum Rand des Textils weiter geleitet und über eine serielle Schnittstelle (Interface) zu einem externen Personal Computer (PC) geführt. Datenpakete eines Sensorsignals werden somit durch eines oder mehrere Netzwerkelemente hindurch bis zum Anschluss weitergereicht. Die Selbstorganisation des Netzwerkes führt dazu, dass an bestimmten Knoten im Netzwerk, den sogenannten Portalknoten bzw. Portalen zum PC, relativ hohe Ströme geschaltet werden müssen, da diese Knoten die gesamte anhängende Baumstruktur des Netzwerkes versorgen müssen.

Ein bisher nicht gelöstes Problem des vorgestellten "Thinking Carpet" ist die mechanische Verbindung der Versorgungsleitungen und der Datenleitungen zum Anschluss und zwischen verschiedenen Bahnen in der Fläche.

Ferner müssen Techniken gefunden werden, mit denen die Produktionskosten von sogenannten intelligenten Textilien ("Smart Textiles") um ungefähr einen Faktor 10 reduziert werden können und mit denen Smart Textiles in einem Rolle-zu-Rolle-Prozess gefertigt werden können, um eine großvolumige Herstellung von Smart Textiles zu ermöglichen.

In [4] ist eine Textilgewebestruktur beschrieben, welche aufweist: eine Mehrzahl von Mikroelektronikkomponenten, welche in der Textilgewebestruktur angeordnet sind; elektrisch leitfähige Fäden, welche die Mehrzahl von Mikroelektronikkomponenten miteinander koppeln; leitfähige Datenübertragungs-Fäden, welche die Mehrzahl von Mikroelektronikkomponenten miteinander koppeln; und elektrisch nicht-leitfähige Fäden. Ferner sind die leitfähigen Fäden und die leitfähigen Datenübertragungs-Fäden am Rande der Textilgewebestruktur jeweils mit elektrischen Schnittstellen bzw. Datenübertragungs-Schnittstellen versehen.

Der Erfindung liegt das Problem zugrunde, auf einfache und kostengünstige Weise einen Textilaufbau bereitzustellen, welcher als textile Flächenverkleidungsstruktur verwendet werden kann.

Das Problem wird durch eine Textilschicht-Anordnung, ein Textilschicht-Array sowie ein Verfahren zum Herstellen einer Textilschicht-Anordnung mit den Merkmalen gemäß den unabhängigen Patentansprüchen gelöst.

Beispielhafte Ausgestaltungen der Erfindung ergeben sich aus den abhängigen Patentansprüchen. Die weiteren Ausgestaltungen der Erfindung, die im Zusammenhang mit der Textilschicht-Anordnung beschrieben sind, gelten sinngemäß auch für das Textilschicht-Array sowie das Verfahren zum Herstellen einer Textilschicht-Anordnung.

Eine Textilschicht-Anordnung weist eine erste Textilschicht sowie eine zweite Textilschicht auf, wobei die zweite Textilschicht auf oder über der ersten Textilschicht ausgebildet ist. Die Textilschicht-Anordnung weist ferner mindestens ein elektronisches Bauelement auf, welches zwischen der ersten Textilschicht und der zweiten Textilschicht ausgebildet ist. Weiterhin weist die Textilschicht-Anordnung mindestens eine in mindestens einem Randbereich der Textilschicht-Anordnung ausgebildete Energieleitung zum Bereitstellen elektrischer Energie auf. Ferner weist die Textilschicht-Anordnung mindestens eine Zuleitung auf, welche mindestens eine Zuleitung das mindestens eine elektronische Bauelement mit der mindestens einen Energieleitung elektrisch koppelt. Die mindestens eine Energieleitung ist in einem Abstand zu dem mindestens einen elektronischen Bauelement angeordnet, und
die mindestens eine Zuleitung ist in einem Winkel zu der mindestens einen Energieleitung angeordnet.

Ein Textilschicht-Array weist eine Mehrzahl von Textilschicht-Anordnungen auf, welche mittels der mindestens einen Energieleitung miteinander gekoppelt sind.

Anschaulich kann unter einem Textilschicht-Array ein Textilschicht-Feld verstanden werden mit einer Mehrzahl von nebeneinander angeordneten Textilschicht-Anordnungen (beispielsweise in Matrix-Form), wobei die Textilschicht-Anordnungen mittels der mindestens einen Energieleitung miteinander gekoppelt sind.

Bei einem Verfahren zum Herstellen einer Textilschicht-Anordnung wird mindestens ein elektronisches Bauelement auf einer ersten Textilschicht angeordnet. Ferner wird eine zweite Textilschicht auf der ersten Textilschicht und auf dem mindestens einen elektronischen Bauelement gebildet. Weiterhin wird mindestens eine Zuleitung von dem mindestens einen elektronischen Bauelement zu mindestens einem Randbereich der Textilschicht-Anordnung hin gebildet. Mittels der mindestens einen Zuleitung wird mindestens eine Energieleitung in einem Winkel zu der mindestens einen Zuleitung und in einem Abstand zu dem mindestens einen elektronischen Bauelement in dem Randbereich der Textilschicht-Anordnung elektrisch kontaktiert.

Ein Aspekt der Erfindung kann darin gesehen werden, dass eine Textilschicht-Anordnung mit einem mehrlagigen Textilaufbau bereitgestellt wird, welche zum Bilden einer großflächigen textilen Flächenverkleidungsstruktur insbesondere für Sensor-/Aktor-Netzwerke (auch Sensor-/Aktuator-Netzwerke genannt) verwendet werden kann.

Unter einem Sensor-/Aktor-Netzwerk kann ein Netzwerk verstanden werden, welches auf Netzwerkelementen basiert, welche jeweils mindestens ein elektronisches Bauelement aufweisen, und welche (beispielsweise in einem regelmäßigen Raster) in einer Flächenverkleidungsstzuktur (beispielsweise einer textilen Flächenverkleidungsstruktur) integriert werden können. Jedes Netzwerkelement des Sensor-/Aktor-Netzwerkes weist ein erstes Sende-/Empfangselement und ein zweites Sende-/Empfangselement auf. Ein Netzwerkelement kann daher auch als Sende-/Empfangs-Einheit bezeichnet werden. Das erste Sende-/Empfangselement ist beispielsweise als Radiofrequenz-Element (RF-Element), beispielsweise als RFID-Tag; ausgebildet, und weist eine einzigartige Kennungs-Information (zum Beispiel eine einzigartige Identifikationsnummer) auf, welche bei einer Installation des Systems einmalig in eine topografische Karte für einen Steuer-PC übernommen werden kann. Zusätzlich können in der Textilstruktur auch RFID-Tags für eine Robotersteuerung mit integriert werden.

Jedes Netzwerkelement kann mit einem oder mehreren Sensorelementen (Sensoren) und/oder Aktorelementen (Aktoren) elektrisch gekoppelt sein, wobei die Sensorelemente bzw. Aktorelemente ebenfalls in der Flächenverkleidungsstruktur integriert sind. Die Netzwerkelemente (im folgenden auch Netzwerkmodule genannt) sind mit einer Versorgungsspannung elektrisch gekoppelt, welche die für den Betrieb der Netzwerkelemente erforderliche elektrische Energie bereitstellt.

Ein Aspekt der Erfindung kann darin gesehen werden, dass die Zuführung der Versorgungsspannung zu den einzelnen Netzwerkelementen (bzw. den in den Netzwerkelementen ausgebildeten elektronischen Bauelementen) mittels einer in einem Randbereich der Textilschicht-Anordnung ausgebildeten Energieleitung erfolgt, wobei die Netzwerkelemente zu der Energieleitung beabstandet sind und mittels der mindestens einen Zuleitung mit der Energieleitung elektrisch gekoppelt sind. Anschaulich weist die Textilschicht-Anordnung mindestens eine gemeinsame Energieversorgungsleitung (Energieleitung) auf, wobei ausgehend von der Energieleitung eine oder mehrere Zuleitungen unter einem Winkel (gemäß Ausführungsbeispielen der Erfindung unter einem von 0°(0 Winkelgrad) bzw. 180° (180 Winkelgrad) verschiedenen Winkel; in einem Ausführungsbeispiel der Erfindung unter einem Winkel in einem Bereich von ungefähr 10° bis 170°, beispielsweise unter einem Winkel in einem Bereich von ungefähr 45° bis 135°, beispielsweise unter einem Winkel von ungefähr 90°) zu den von der Energieleitung beabstandeten Netzwerkelementen bzw. elektronischen Bauelementen verlaufen. Mit anderen Worten kann mittels der mindestens einen Energieleitung die Zuführung einer Versorgungsspannung zu jedem einzelnen Netzwerkelement entlang der Kanten des Textilaufbaus erfolgen.

Datenleitungen sind in dem Sensor-/Aktuator-Netzwerk nicht vorgesehen, da eine Datenübertragung bzw. Signalübertragung (zum Beispiel von Sensorsignalen und/oder Aktorsignalen) beispielsweise drahtlos oder mittels Powerline-Communication (PLC) erfolgt. Alternativ können die Netzwerkelemente mittels Leiterbahnen untereinander verbunden und an der Versorgungsspannung angeschlossen sein. In diesem Fall kann ein Power-Routing-Verfahren zum automatischen Abschalten von kurzgeschlossenen Leitungen verwendet werden, wie es an sich beispielsweise in [2] beschrieben ist.

Ein Vorteil eines Sensor-/Aktor-Netzwerkes kann darin gesehen werden, dass nur geringe Anforderungen an die Übertragungskapazität von Datenleitungen (sofern vorhanden) gestellt werden, da Datenpakete eines Sensorsignals nicht drahtgebunden durch viele Netzwerkelemente bis zum Anschluss weitergereicht werden müssen sondern beispielsweise drahtlos übermittelt werden können. Dadurch wird der Netzwerkverkehr in dem Sensor-/Aktor-Netzwerk verringert, so dass Kollisionen zwischen Datenpakten und ein damit möglicherweise einhergehender Verlust von Datenpaketen ganz oder nahezu vollständig vermieden werden.

Ein weiterer Vorteil des Sensor-/Aktor-Netzwerkes gegenüber dem oben erwähnten "Thinking Carpet" kann darin gesehen werden, dass zum Aufbau der Datenpfade keine Baumstruktur bzw. Selbstorganisation der Netzwerkelemente erforderlich ist. Damit wird bei dem Sensor-/Aktor-Netzwerk vermieden, dass bestimmte Knoten des Netzwerkes sehr hohe Ströme schalten müssen.

Ein anderer Aspekt der Erfindung kann darin gesehen werden, dass mittels der Textilschicht-Anordnung eine Lösung bereitgestellt wird für eine mechanische Verbindung der Versorgungsleitungen und der Datenleitungen zum Anschluss und zwischen verschiedenen Textilbahnen in der Fläche.

Ein Vorteil der Erfindung kann darin gesehen werden, dass unter Verwendung der bereitgestellten Textilschicht-Anordnung bzw. des Verfahrens zum Herstellen einer Textilschicht-Anordnung sogenannte intelligente Textilien ("Smart Textiles") auf einfache und kostengünstige Weise in einem Rolle-zu-Rolle-Prozess gefertigt werden können, so dass die Produktionskosten solcher intelligenter Textilien stark reduziert werden können.

Zum Beispiel wird bei der Textilschicht-Anordnung ein aufwendiges Einweben von Datenleitungen in das Textil zum Verbinden der Module ganz oder nahezu vollständig vermieden.

Ein anderer Aspekt der Erfindung kann darin gesehen werden, dass großflächige Sensor-und Aktuator-Flächenverkleidungs-Elemente bereitgestellt werden, mit deren Hilfe es möglich ist, Applikationen von "intelligenten Umgebungen" zu realisieren.

Gemäß einer Ausgestaltung der Erfindung sind/ist die erste Textilschicht und/oder die zweite Textilschicht als elektrisch nicht-leitende Textilschicht ausgebildet.

Die erste Textilschicht und/oder die zweite Textilschicht können/kann ein Polyester-Material aufweisen bzw. aus einem Polyester-Material bestehen. Die erste Textilschicht und/oder die zweite Textilschicht können/kann beispielsweise ein Trevira® CS Material aufweisen oder daraus bestehen. Alternativ können andere geeignete Materialien für die erste Textilschicht und/oder die zweite Textilschicht verwendet werden.

Die erste Textilschicht und/oder die zweite Textilschicht können/kann eine Vlies-Struktur aufweisen, zum Beispiel mit einem Flächengewicht von ungefähr 200 g/m² bis 800 g/m², beispielsweise 350 g/m² bis 650 g/m², beispielsweise ungefähr 500 g/m².

Gemäß einer anderen Ausgestaltung der Erfindung weist die Textilschicht-Anordnung mindestens einen Zwischenträger (im folgenden auch Interposer genannt) auf, wobei das mindestens eine elektronische Bauelement auf einer ersten Hauptoberfläche des mindestens einen Zwischenträgers ausgebildet ist, und wobei eine der ersten Hauptoberfläche gegenüberliegende zweite Hauptoberfläche des mindestens einen Zwischenträgers eine gemeinsame Grenzfläche aufweist mit einer oberen Oberfläche (anschaulich der Oberseite) der ersten Textilschicht oder mit einer unteren Oberfläche (anschaulich der Unterseite) der zweiten Textilschicht.

Anschaulich kann der Zwischenträger so angeordnet sein, dass das mindestens eine auf der ersten Hauptoberfläche des Zwischenträgers ausgebildete elektronische Bauelement der Oberseite oder der Unterseite der Textilschicht-Anordnung zugewandt ist.

Gemäß einer anderen Ausgestaltung der Erfindung ist es vorgesehen, dass die mindestens eine Zuleitung, welche das mindestens eine elektronische Bauelement mit der mindestens einen Energieleitung elektrisch koppelt, auf der oberen Oberfläche der ersten Textilschicht ausgebildet ist.

In einer anderen Ausgestaltung der Erfindung ist es vorgesehen, dass die mindestens eine Zuleitung auf der oberen Oberfläche der zweiten Textilschicht ausgebildet ist.

Gemäß einer anderen Ausgestaltung der Erfindung weist das mindestens eine elektronische Bauelement mindestens einen integrierten Schaltkreis auf. Das mindestens eine elektronische Bauelement kann als integrierter Schaltkreis ausgebildet sein.

Gemäß einer anderen Ausgestaltung der Erfindung weist das mindestens eine elektronische Bauelement mindestens ein Sende-/Empfangs-Element auf. Das mindestens eine Sende-/Empfangselement kann ein RF-Element (Radiofrequenz-Element) aufweisen, beispielsweise einen aktiven oder passiven RFID-Tag.

Anschaulich kann das mindestens eine elektronische Bauelement als ein Netzwerkelement bzw. eine Sende-/Empfangs-Einheit eines im vorangegangenen beschriebenen Sensor-/Aktor-Netzwerkes ausgebildet sein.

Gemäß einer anderen Ausgestaltung der Erfindung ist die mindestens eine Energieleitung mit einem hohen elektrischen Potential und/oder mit einem niedrigen elektrischen Potential elektrisch koppelbar. Die Energieleitung kann beispielsweise mit einer elektrischen Versorgungsspannungsquelle elektrisch gekoppelt sein.

Gemäß einer anderen Ausgestaltung der Erfindung weist die Textilschicht-Anordnung mindestens eine elektrisch leitfähige Struktur auf. Die mindestens eine elektrisch leitfähige Struktur kann zwischen der ersten Textilschicht und der zweiten Textilschicht ausgebildet sein. Alternativ kann die mindestens eine elektrisch leitfähige Struktur auf der oberen Oberfläche (anschaulich auf der Oberseite) der zweiten Textilschicht ausgebildet sein.

Gemäß einer anderen Ausgestaltung der Erfindung ist die mindestens eine elektrisch leitfähige Struktur als elektrisch leitfähige Textilstruktur ausgebildet.

Gemäß einer anderen Ausgestaltung der Erfindung ist die mindestens eine elektrisch leitfähige Struktur als Sensor-Struktur bzw. Sensorelement ausgebildet, zum Beispiel als kapazitives Sensorelement. Die elektrisch leitfähige Struktur kann als Sensorfläche ausgebildet sein.

Eine Sensorfläche kann beispielsweise unter Verwendung eines Carbon-Materials gedruckt werden oder kann alternativ aus Textil bestehend aus leitfähigen Polymeren gebildet werden.

Alternativ kann die Sensorfläche mittels Aufdruckens eines metallgefüllten Klebers gebildet werden. Alternativ kann zum Bilden der Sensorfläche lokal eine galvanische Metallschicht aufgebracht werden.

Die mindestens eine elektrisch leitfähige Struktur (zum Beispiel das Sensorelement) kann mit dem mindestens einen elektronischen Bauelement elektrisch gekoppelt sein.

Gemäß einer anderen Ausgestaltung der Erfindung weist die Textilschicht-Anordnung eine elektrisch leitfähige Schicht auf, wobei die erste Textilschicht auf der elektrisch leitfähigen Schicht ausgebildet ist.

Die elektrisch leitfähige Schicht kann als elektrisch leitfähige Textilschicht ausgebildet sein. Eine als elektrisch leitfähige Textilschicht ausgebildete elektrisch leitfähige Schicht kann eine Vlies-Struktur aufweisen, zum Beispiel mit einem Flächengewicht von ungefähr 10 g/m² bis 500 g/m², beispielsweise 50 g/m² bis 250 g/m², beispielsweise ungefähr 100 g/m².

Die elektrisch leitfähige Schicht kann eine Dicke von ungefähr 1 µm bis 200 µm aufweisen.

Gemäß einer anderen Ausgestaltung der Erfindung ist die elektrisch leitfähige Schicht mit einem niedrigen elektrischen Potential (zum Beispiel dem elektrischen Masse-Potential) elektrisch koppelbar.

Gemäß einer anderen Ausgestaltung der Erfindung ist das mindestens eine elektronische Bauelement mit der elektrisch leitfähigen Schicht elektrisch gekoppelt.

Gemäß einer anderen Ausgestaltung der Erfindung weist die Textilschicht-Anordnung mindestens eine zumindest in der ersten Textilschicht ausgebildete Kontakt-Struktur auf zum elektrischen Kontaktieren des mindestens einen elektronischen Bauelementes mit der elektrisch leitfähigen Schicht durch die erste Textilschicht hindurch.

Anschaulich kann mittels Durchkontaktierens durch die elektrisch nicht-leitende erste Textilschicht hindurch das elektronische Bauelement mit der elektrisch leitfähigen Schicht (welche zum Beispiel als eine Masseleitung ausgebildet ist) elektrisch kontaktiert werden. Mit anderen Worten bildet die Kontakt-Struktur einen Durchkontakt zum elektrischen Kontaktieren des elektronischen Bauelementes mit der elektrisch leitfähigen Schicht (Masseleitung) durch die nicht-leitende erste Textilschicht hindurch.

Die Durchkontaktierung kann unter Verwendung von Metall-Filamenten gebildet werden. Das Bilden eines Durchkontakts kann zum Beispiel mittels Verstickens leitfähiger Filamente (zum Beispiel Kupfer-Drähte, versilberte Kupfer-Drähte, Stahldrähte, Metalldrähte in Kombination mit Polyester-Filamenten bzw. Aramid-Garnen) oder alternativ mittels Vernietens oder Crimpens (d.h. Ausbilden einer Klemmverbindung) an der entsprechenden Stelle erfolgen.

Gemäß einer anderen Ausgestaltung der Erfindung weist die mindestens eine Kontakt-Struktur mindestens ein elektrisch leitfähiges Filament auf, welches durch die erste Textilschicht hindurch verläuft.

Ein Aspekt der Erfindung kann darin gesehen werden, dass das mindestens eine elektronische Bauelement mittels punktuellen Durchkontaktierens durch die erste Textilschicht hindurch mit einer Masseleitung elektrisch gekoppelt werden kann, wobei das elektronische Bauelement und die Masseleitung in unterschiedlichen Ebenen der Textilschicht-Anordnung ausgebildet sind.

Gemäß einer anderen Ausgestaltung der Erfindung weist die Textilschicht-Anordnung mindestens eine zumindest in der zweiten Textilschicht ausgebildete Kontakt-Struktur auf zum elektrischen Kontaktieren des mindestens einen elektronischen Bauelementes mit der mindestens einen (zum Beispiel als Sensor-Struktur ausgebildeten) elektrisch leitfähigen Struktur und/oder mit der mindestens einen Zuleitung durch die zweite Textilschicht hindurch. Anschaulich kann das elektronische Bauelement mittels Durchkontaktierens durch die zweite Textilschicht hindurch mit der mindestens einen Zuleitung und/oder mit der mindestens einen elektrisch leitfähigen Struktur elektrisch kontaktiert werden, beispielsweise falls die mindestens eine Zuleitung und/oder die mindestens eine elektrisch leitfähige Struktur auf der oberen Oberfläche der zweiten Textilschicht ausgebildet sind/ist.

Gemäß einer anderen Ausgestaltung der Erfindung weist die mindestens eine Energieleitung mindestens eine elektrisch leitfähige Anschluss-Textilschicht auf. Die mindestens eine Energieleitung kann als elektrisch leitfähige (Anschluss-)Textilschicht, zum Beispiel als elektrisch leitfähiges Textilband, ausgebildet sein.

Gemäß einer anderen Ausgestaltung der Erfindung ist die mindestens eine elektrisch leitfähige Anschluss-Textilschicht so ausgebildet, dass sie einen in dein mindestens einen Randbereich der Textilschicht-Anordnung ausgebildeten Endabschnitt der zweiten Textilschicht umschließt.

Gemäß einer anderen Ausgestaltung der Erfindung weist die Textilschicht-Anordnung mindestens eine Klemmschiene auf zum elektrischen Kontaktieren der mindestens einen elektrisch leitfähigen Anschluss-Textilschicht, welche mindestens eine Klemmschiene den mindestens einen Randbereich der Textilschicht-Anordnung umschließt.

Die mindestens eine Klemmschiene kann aus einem elektrisch nicht-leitfähigen Material (zum Beispiel einem Kunststoff-Material) bestehen. Alternativ kann die Klemmschiene ein elektrisch leitfähiges Material aufweisen, welches mit einer elektrisch nicht-leitfihigen Beschichtung versehen ist.

Gemäß einer anderen Ausgestaltung der Erfindung ist die Textilschicht-Anordnung als Flächenverkleidungsstruktur ausgebildet, zum Beispiel als Bodenverkleidungsstruktur bzw. Bodenverkleidung.

Gemäß einer anderen Ausgestaltung der Erfindung wird bei einem Verfahren zum Herstellen einer Textilschicht-Anordnung die elektrisch leitfähige Schicht auf eine der zweiten Textilschicht abgewandte Oberfläche der ersten Textilschicht aufgedruckt. Mit anderen Worten wird gemäß dieser Ausgestaltung die elektrisch leitfähige Schicht auf eine untere Oberfläche (anschaulich die Unterseite) der ersten Textilschicht aufgedruckt.

Zum Aufdrucken der elektrisch leitfähigen Schicht kann ein elektrisch leitfähiges PolymerMaterial verwendet werden.
Ferner kann die aufgedruckte elektrisch leitfähige Schicht galvanisch verstärkt werden.

Gemäß einer anderen Ausgestaltung der Erfindung wird eine zweite elektrisch leitfähige Schicht ganzflächig auf die obere Oberfläche (d.h. die Oberseite) der ersten Textilschicht aufgebraucht

Eine auf der oberen Oberfläche der ersten Textilschicht ausgebildete zweite elektrisch leitfähige Schicht kann derart strukturiert werden, dass mindestens eine elektrische Leiterbahn (zum Beispiel die mindestens eine Zuleitung) und/oder mindestens eine Sensor-Struktur (zum Beispiel eine Sensorfläche) auf der ersten Textilschicht gebildet wird. Gemäß einer anderen Ausgestaltung der Erfindung wird die zweite elektrisch leitfähige Schicht ganzflächig auf die obere Oberfläche (d.h. die Oberseite) der zweiten Textilschicht aufgebracht.

Eine auf der oberen Oberfläche der zweiten Textilschicht ausgebildete zweite elektrisch leitfähige Schicht kann derart strukturiert werden, dass mindestens eine elektrische Leiterbahn (zum Beispiel die mindestens eine Zuleitung) und/oder mindestens eine Sensor-Struktur (zum Beispiel eine Sensorfläche) auf der zweiten Textilschicht gebildet wird.

Gemäß einer anderen Ausgestaltung der Erfindung wird das mindestens eine elektronische Bauelement mittels elektrischen Durchkontaktierens durch die erste Textilschicht hindurch mit der elektrisch leitfähigen Schicht elektrisch gekoppelt.

Das Durchkontaktieren kann unter Verwendung eines oder mehrerer der folgenden Verfahren erfolgen:
- ein Verfahren zum Versticken elektrisch leitfähiger Filamente;
- ein Verfahren zum Vernieten;
- ein Crimp-Verfahren.

Gemäß einer anderen Ausgestaltung der Erfindung werden die erste Textilschicht und die zweite Textilschicht unter Verwendung eines Laminier-Verfahrens miteinander verbunden.

Ein Aspekt der Erfindung kann darin gesehen werden, dass eine Textilschicht-Anordnung mit einem mehrlagigen Textilaufbau (anders ausgedrückt, einem gestackten Textilaufbau) bereitgestellt wird, welcher Textilautbau eine Abfolge von leitfähigen und nichtleitfähigen Textillagen aufweist, wobei die einzelnen Textillagen entsprechend der gewünschten elektrischen Eigenschaften unter Verwendung textiler Verbindungstechniken wie zum Beispiel Sticken, Rascheln, Nähen, Wirken mit wahlweise leitfähigen oder nichtleitfähigen Filamenten oder auch unter Verwendung von Klebetechniken mit leitfähigen oder nichtleitfähigen bzw. anisotrop leitfähigen Klebern miteinander verbunden werden können.

Ein anderer Aspekt der Erfindung kann darin gesehen werden, dass ein Kontaktieren von in die Textilschicht-Anordnung integrierten Elektronikmodulen bzw. elektronischen Bauelementen (zum Beispiel eines Netzwerkelementes) beispielsweise mittels Klebens mit nichtleitfähigem oder anisotrop leitendem Kleber (wie beispielsweise in [3] beschrieben) erfolgt, alternativ mittels Lötens, Laser-Schweißens oder Verstickens mit leitfähigen Filamenten.

Ein Vorteil der Erfindung kann darin gesehen werden, dass die für eine Applikation gewünschte Elektronik mit einem oder mehreren in der Textilschicht-Anordnung integrierten Sensorelementen (Sensorflächen) und/oder Aktuator-Elementen so verbunden werden kann, dass zusätzlich zu der elektrischen Verdrahtung ein mechanischer Schutz während des Gebrauchs gewährleistet wird.

Ferner können Kurzschlüsse in der Textilschicht-Anordnung beispielsweise dadurch vermieden werden, dass elektrische Leitungen, welche mit unterschiedlichen elektrischen Potentialen gekoppelt sind (zum Beispiel die mindestens eine Energieleitung und eine als Masseleitung ausgebildete elektrisch leitfähige Schicht), in unterschiedlichen Ebenen der Textilschicht-Anordnung ausgebildet sind.

Ein anderer Vorteil der Erfindung kann darin gesehen werden, dass durch den Textilaufbau der Textilschicht-Anordnung eine Abschirmung gegen Störeinflüsse und ein einfacher und robuster elektrischer Anschluss für eine Versorgungsspannung erreicht werden.

Ein anderer Vorteil der Erfindung kann darin gesehen werden, dass mit der Textilschicht-Anordnung bzw. mit dem Verfahren zum Herstellen einer Textilschicht-Anordnung unter Verwendung einfacher, preiswerter und bereits standardmäßig vorhandener Flächenbildungsverfahren eine gewünschte mehrlagige Flächenverkleidungsstruktur mit allen gewünschten Eigenschaften geschaffen sind bzw. werden.

Ein anderer Aspekt der Erfindung kann daher darin gesehen werden, dass bei dem mehrlagigen Textilaufbau der Textilschicht-Anordnung mit der gewählten Abfolge von leitfähigen, nichtleitfähigen Textillagen und textilen Verbindungstechniken bzw. Klebetechniken mit leitfähigen bzw. nichtleitfähigen Materialien eine Flächenverkleidungsstruktur bereitgestellt wird, welche Flächenverkleidungsstruktur ein einfaches Kontaktieren der integrierten Elektronik (z.B. integrierte elektronische Bauelemente bzw. Schaltkreise eines oder mehrerer Netzwerkelemente), der Sensorflächen und deren Anschlüsse gewährleistet, und welche Flächenverkleidungsstruktur ferner eine Abschirmung, Masseflächen und einen einfachen Netzanschluss gewährleistet. Außerdem können die nichtleitfähigen Textillagen antistatisch beschichtet werden, um einen ESD-Schutz, d.h. einen Schutz vor elektrostatischen Entladungen (ESD: Electrostatic Discharge), zu gewährleisten.

Ein anderer Aspekt der Erfindung kann darin gesehen werden, dass es mittels Durchkontaktierens zwischen verschiedenen Schichten einer Textilschicht-Anordnung gelingt, einen Großteil separater Zuleitungen (bzw. elektrisch leitfähiger Bahnen) einzusparen. Die textilen Bahnen mit der integrierten Elektronik können mittels einfachen Aneinanderlegens und Verklebens mit leitfähigen Klebebändern in einer Fläche installiert werden. Das Anschließen an einen elektrischen Netzanschluss kann beispielsweise unter Verwendung einer einfachen Klemmleiste erfolgen. Auf aufwendige Stecker kann daher bei dieser Technik verzichtet werden. Der Mehrlagenaufbau kann so ausgebildet sein, dass nur eine Textillage der Textilschicht-Anordnung mit aufwendiger Kontaktierungstechnik verarbeitet werden muss. Die anderen Textillagen können mittels ganzflächigen Laminierens ohne Justieraufwand miteinander verbunden werden. Lediglich das um die Kante geführte leitfähige Textil für den großflächigen Netzanschluss wird in einem Arbeitsschritt auf die Oberfläche geklebt oder festgenäht. Durch eine geeignete Wahl des Klebers beim Laminieren der einzelnen Textilschichten kann die Mehrlagenstruktur der Textilschicht-Anordnung bei Bedarf wasserfest gemacht werden und die integrierte Elektronik vor einem Kurzschluss bei Nässe geschützt werden.

Ein anderer Aspekt der Erfindung kann darin gesehen werden, dass eine Anwendung beschrieben wird, die zum Beispiel einen Fußboden als ein großflächiges intelligentes Sensor-Netzwerk einsetzt (sogenannter Sensor Floor). Unsichtbar unter beliebige Bodenbeläge installiert, vereinfacht und verbessert die beschriebene Technologie jene Funktionen, welche derzeit von vielen getrennten Systemen erfüllt werden müssen. Darüber hinaus werden aber auch völlig neue Anwendungen ermöglicht, die von der Erhöhung der persönlichen Sicherheit, über innovative Komfortfunktionen bis zur Einsparung von Energie reichen.

Vorteilhafte Anwendungen ergeben sich beispielsweise in den Bereichen Pflege und Gesundheit (zum Beispiel Sturz-Erkennung: ein Sensor-Floor mit integrierten Sensoren kann "erkennen", ob eine auf dem Boden gestürzte Person liegen bleibt oder wieder aufsteht), Komfort und Sicherheit, Gebäude-Automation, Facility-Management und Transport-Logistik. Hierbei kommen einerseits Sensoren zum Einsatz, die die Anwesenheit von Personen auf einem Fußboden erkennen können. Andererseits ermöglichen in einen Boden integrierte Landmarken eine genaue Lokalisation von Fahrzeugen wie zum Beispiel Robotern oder Rollstühlen. Als Basistechnologie können Sensoren und mikroelektronische Komponenten verwendet werden, die in Textilien eingebettet sind.

Ein anderer Aspekt der Erfindung kann darin gesehen werden, dass bei einem Textilschicht-Array anschaulich mehrere einzelne Textilschicht-Anordnungen (auch als textile Bahnen bzw. Textilbahnen bezeichnet) mittels einfachen Aneinanderlegens zu einer großen Fläche zusammengefügt werden können. Auf diese Weise kann eine großflächige Flächenverkleidungsstruktur geschaffen werden, mit lateralen Abmessungen von beispielsweise ungefähr 10 cm bis 10 m. Die einzelnen Textilschicht-Anordnungen bzw. Textilbahnen des Textilschicht-Arrays sind mittels der in den Textilschicht-Bahnen ausgebildeten Energieleitungen miteinander gekoppelt, zum Beispiel unter Verwendung einer oder mehrerer Klemmschienen, elektrisch leitfähigem Kleber oder elektrisch leitfähigem Klebeband.

Eine Textilschicht-Anordnung bzw. ein Textilschicht-Array kann auf einem Untergrund (zum Beispiel einem Estrich) aufgebracht werden. Ferner kann die Textilschicht-Anordnung bzw. das Textilschicht-Array mit einem handelsüblichen Bodenbelag (zum Beispiel Kunststoffboden, Gummiboden, Laminat, Parkett, Fliesen, Steinbelag oder andere geeignete Bodenbeläge) abgedeckt werden. Bei einer Abdeckung mit Fliesen oder einem Steinbelag kann eine weitere Zwischenschicht (zum Beispiel Watec®2E) eingefügt werden, welche Zwischenschicht ein armiertes Tragesystem bildet für im Dünnbett verlegte keramische Fliesen im Innenbereich und zur Entlüftung sowie zur Entkopplung des Belags vom Untergrund dient.

Ausführungsbeispiele der Erfindung sind in den Figuren dargestellt und werden im folgenden näher erläutert. In den Figuren sind gleiche oder ähnliche Elemente, soweit sinnvoll, mit gleichen oder identischen Bezugszeichen versehen. Die in den Figuren gezeigten Darstellungen sind schematisch und daher nicht maßstabsgetreu gezeichnet.

Es zeigen
- Figur 1A und Figur 1B: Querschnittsansichten einer Textilschicht-Anordnung gemäß einem ersten Ausführungsbeispiel der Erfindung;
- Figur 2: eine Draufsicht einer Textilschicht-Anordnung gemäß einem zweiten Ausführungsbeispiel der Erfindung;
- Figur 3: eine Draufsicht einer Textilschicht-Anordnung gemäß einem dritten Ausführungsbeispiel der Erfindung;
- Figur 4: eine Draufsicht einer Textilschicht-Anordnung gemäß einem vierten Ausführungsbeispiel der Erfindung;
- Figur 5: eine Draufsicht einer Textilschicht-Anordnung gemäß einem fünften Ausführungsbeispiel der Erfindung;
- Figur 6A und Figur 6B: Querschnittsansichten einer Textilschicht-Anordnung gemäß einem sechsten Ausführungsbeispiel der Erfindung;
- Figur 7: eine Querschnittsansicht einer Textilschicht-Anordnung gemäß einem siebten Ausführungsbeispiel der Erfindung.

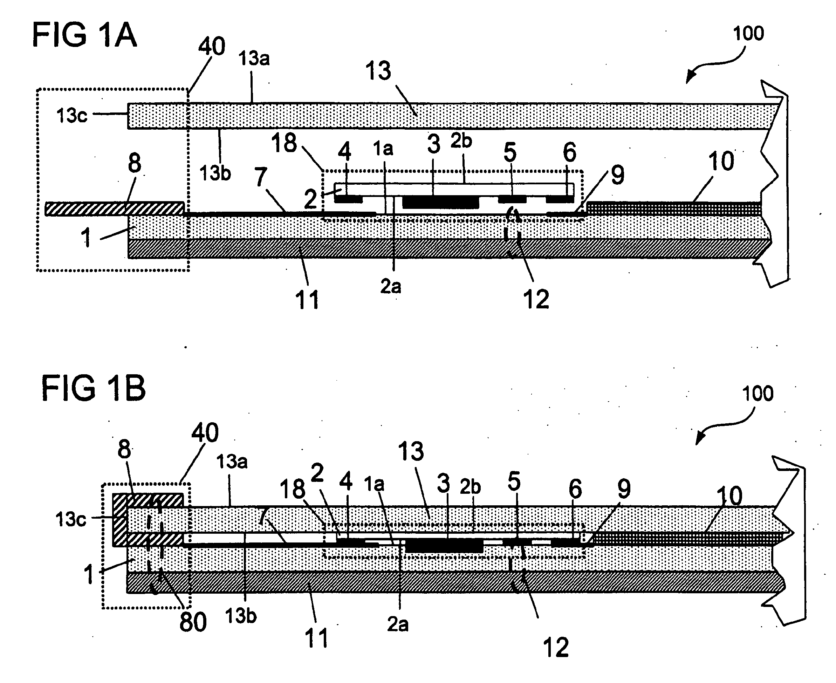

**Fig.1A** und **Fig.1B** zeigen jeweils eine Teilquerschnittsansicht einer Textilschicht-Anordnung 100 gemäß einem ersten Ausführungsbeispiel der Erfindung. Die Textilschicht-Anordnung 100 weist eine erste Textilschicht 1 und eine zweite Textilschicht 13 auf, welche als elektrisch nicht-leitende Textilschichten ausgebildet sind.

Fig.1A zeigt die Textilschicht-Anordnung 100 während eines Prozessschrittes eines Verfahrens zum Herstellen der Textilschicht-Anordnung zu einem Zeitpunkt vor einem Verbinden der ersten Textilschicht 1 mit der zweiten Textilschicht 13, und Fig.1B zeigt die Textilschicht-Anordnung 100 während eines anderen Prozessschrittes des Verfahrens nach dem Verbinden der ersten Textilschicht 1 mit der zweiten Textilschicht 13.

Die zweite Textilschicht 13 ist auf bzw. über der ersten Textilschicht 1 ausgebildet und dient anschaulich als Abdeckschicht der Textilschicht-Anordnung 100. Die mehrlagige Textilschicht-Anordnung 100 dient zur Verwendung in einem großflächigen Sensorboden mit kapazitiven Sensoren. Die Textilschicht-Anordnung 100 weist ein als Silizium-Chip ausgebildetes elektronisches Bauelement 3 auf, welches zwischen der ersten Textilschicht 1 und der zweiten Textilschicht 13 ausgebildet ist. Anschaulich dient die elektrisch nichtleitfähige erste Textilschicht 1 als Basis für ein oder mehrere in die Textilschicht-Anordnung 100 integrierte elektronische Bauelemente bzw. Mikroelektronik und deren Verdrahtung. Die in die Textilschicht-Anordnung 100 integrierte Mikroelektronik bzw. elektronischen Bauelemente (in Fig.1A und Fig.1B beispielhaft durch das elektronische Bauelement 3 bzw. den Chip 3 dargestellt) ist auf einem (beispielsweise flexiblen) Zwischenträger 2 (Interposer) ausgebildet. Der Zwischenträger 2 bzw. Interposer 2 dient anschaulich als Träger für die in die Textilschicht-Anordnung 100 integrierte Elektronik. Der Zwischenträger 2 weist eine erste Hauptoberfläche 2a und eine der ersten Hauptoberfläche 2a gegenüberliegende zweite Hauptoberfläche 2b auf, wobei das elektronische Bauelement 3 auf der ersten Hauptoberfläche 2a des Zwischenträgers 2 ausgebildet ist.

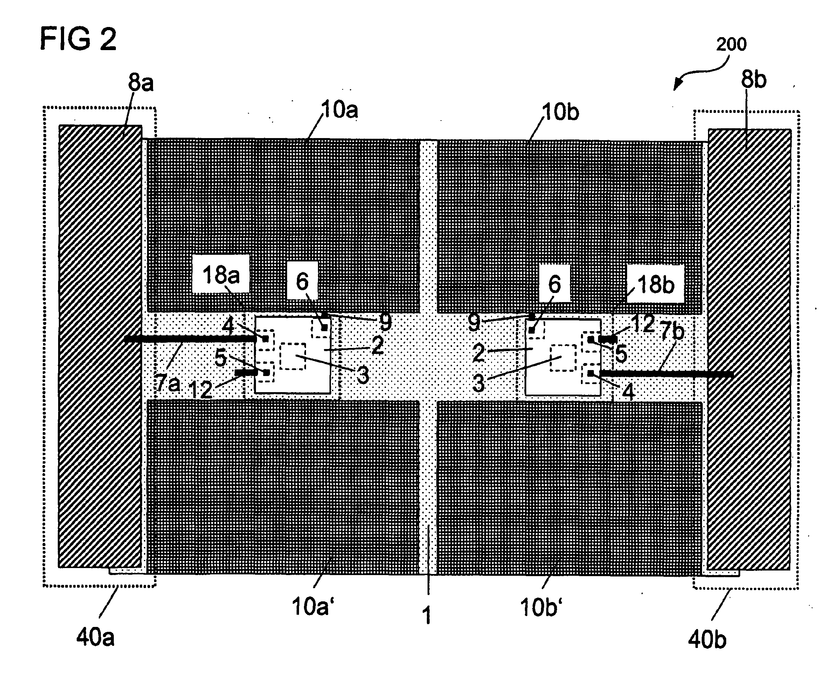

Die Textilschicht-Anordnung 100 weist eine Energieleitung 8 zum Bereitstellen elektrischer Energie auf, welche Energieleitung 8 in einem Randbereich 40 der Textilschicht-Anordnung 100 ausgebildet ist. Die Energieleitung 8 ist mit einer äußeren Versorgungsspannungsquelle elektrisch koppelbar. Die Energieleitung 8 verläuft senkrecht zur Zeichenebene der Figuren 1A und 1B , vgl. Fig.2. Die Textilschicht-Anordnung weist ferner eine auf einer oberen Oberfläche 1a der ersten Textilschicht 1 ausgebildete Zuleitung 7 auf, welche Zuleitung 7 das elektronische Bauelement 3 mit der Energieleitung 8, welche Energieleitung 8 in einem Abstand zu dem elektronischen Bauelement 3 angeordnet ist, elektrisch koppelt. Die Zuleitung 7 ist in einem (von Null verschiedenen) Winkel zu der Energieleitung 8 angeordnet. Anschaulich verläuft die Zuleitung 7 senkrecht, d.h. unter einem Winkel von 90° (90 Winkelgrad) zu der Energieleitung 8 (vgl. Fig.2). Die Energieleitung 8 und die Zuleitung 7 können jedoch auch einen anderen (von 0° bzw. 180° verschiedenen) Winkel miteinander bilden.

Die Energieleitung 8 weist eine Anschluss-Textilschicht auf, welche Anschluss-Textilschicht als elektrisch leitfähiges Textilband ausgebildet ist. Gemäß dem gezeigten Ausführungsbeispiel wird bei dem Verfahren zum Herstellen der Textilschicht-Anordnung 100 das Textilband 8 in dem Randbereich 40 der Textilschicht-Anordnung 100 auf der ersten Textilschicht 1 (genauer auf der oberen Oberfläche 1a der ersten Textilschicht 1 ) aufgebracht und zum Beispiel mittels textiler Standard-Verbindungstechniken mit der ersten Textilschicht 1 verbunden, wobei anschaulich ein Teil des Textilbandes 8 übersteht, d.h. nicht mit der ersten Textilschicht 1 verbunden ist (siehe Fig.1 A). In einem anderen Prozessschritt des Verfahrens, nachdem die erste Textilschicht 1 und die zweite Textilschicht 13 miteinander verbunden sind, wird das Textilband 8 anschaulich um die (in Fig.1A linke) Kante 13c der zweiten Textilschicht 13 herum nach oben geklappt, so dass das Textilband bzw. die Anschluss-Textilschicht 8 einen in dem Randbereich 40 der Textilschicht-Anordnung 100 ausgebildeten Endabschnitt der zweiten Textilschicht 13 umschließt (siehe Fig.1 B), wobei ein erster Teilbereich der Anschluss-Textilschicht 8 zwischen der ersten Textilschicht 1 und der zweiten Textilschicht 13 ausgebildet ist, ein zweiter Teilbereich der Anschluss-Textilschicht 8 auf der Kante 13c der zweiten Textilschicht 13 ausgebildet ist, und ein dritter Teilbereich der Anschluss-Textilschicht 8 auf einer oberen Oberfläche 13a der zweiten Textilschicht 13 ausgebildet ist.

Auf der ersten Hauptoberfläche 2a des Zwischenträgers 2 sind ferner ein erster elektrischer Kontakt (erstes Kontaktpad) 4, ein zweiter elektrischer Kontakt (zweites Kontaktpad) 5 und ein dritter elektrischer Kontakt (drittes Kontaktpad) 6 ausgebildet. Anschaulich weist die Mikroelektronik 3 elektrische Anschlüsse (nicht gezeigt) zum Anschließen einer Versorgungsspannung, Masse und eines elektrischen Sensor-Elementes 10 auf, wobei die Anschlüsse der Mikroelektronik 3 über das erste Kontaktpad 4 (Versorgungsspannung), das zweite Kontaktpad 5 (Masse) und das dritte Kontaktpad 6 (Sensoranschluss) nach außen geführt werden.

Eine Versorgungsspannung kann an das elektrisch leitfähige Textilband 8 angeschlossen werden und mittels der (elektrisch leitfähigen) Zuleitung 7 an dem ersten Kontaktpad 4 des Zwischenträgers 2 bereitgestellt werden. Anschaulich bildet die Anschluss-Textilschicht 8 (Textilband 8) den Anschluss der Versorgungsspannung an der Oberseite der mehrlagigen Textilstruktur 100.

Der Interposer 2, die darauf ausgebildete Mikroelektronik 3 und die Kontaktpads 4, 5, 6 bilden zusammen anschaulich ein Elektronikmodul 18, welches Elektronikmodul 18 beispielsweise als ein Netzwerkelement eines Sensor-/Aktor-Netzwerkes ausgebildet sein kann. Das Elektronikmodul 18 bzw. der Zwischenträger 2 des Elektronik-Moduls 18 wird so angeordnet, dass nach dem Verbinden der ersten Textilschicht 1 mit der zweiten Textilschicht 13 die zweite Hauptoberfläche 2b des Zwischenträgers 2 eine gemeinsame Grenzfläche aufweist mit der unteren Oberfläche 13b der zweiten Textilschicht 13 (siehe Fig. 1 B). Mit anderen Worten wird der Zwischenträger 2 so angeordnet, dass die auf dem Zwischenträger 2 ausgebildete Mikroelektronik 3 der oberen Oberfläche 1a der ersten Textilschicht 1 zugewandt ist.

Der erste elektrische Kontakt 4 (erstes Kontaktpad 4) wird mit der Zuleitung 7 elektrisch verbunden (vgl. Fig.1B), so dass dem Zwischenträger 2 bzw. dem darauf ausgebildeten elektronischen Bauelement 3 mittels der Energieleitung 8, der Zuleitung 7 und dem ersten Kontaktpad 4 elektrische Energie (in Form einer Versorgungsspannung) bereitgestellt werden kann.

Die Textilschicht-Anordnung 100 weist ferner eine elektrisch leitfähige Schicht 11 auf, wobei die erste Textilschicht 1 auf der elektrisch leitfähigen Schicht 11 ausgebildet ist. Die elektrisch leitfähige Schicht 11 ist als elektrisch leitfähige Textilschicht ausgebildet und kann beispielsweise ein möglichst niederohmiges Textil-Material aufweisen. Die elektrisch leitfähige Schicht 11 bildet anschaulich eine Masseleitung der Textilschicht-Anordnung 100, eine Abschirmung zum Untergrund sowie einen elektrischen Anschluss für ein elektrisches Netzteil.

Gemäß einer anderen (nicht gezeigten) Ausgestaltung der Erfindung kann die elektrisch leitfähige Schicht 11 aus einer leitfähigen Schicht bestehen, welche auf die erste Textilschicht 1 (bzw. auf eine der oberen Oberfläche 1a gegenüber liegende untere Oberfläche der ersten Textilschicht 1) aufgebracht ist (zum Beispiel mittels Aufdruckens eines leitfähigen Polymers).

Die Textilschicht-Anordnung 100 weist ferner eine elektrisch leitfähige Bahn 9 auf, welche elektrisch leitfähige Bahn 9 auf der ersten Textilschicht 1 ausgebildet ist. Weiterhin weist die Textilschicht-Anordnung 100 eine elektrisch leitfähige Textilstruktur 10 auf, welche als eine Sensorfläche 10 für einen kapazitiven Sensor des Sensorbodens dient. Die elektrisch leitfähige Textilstruktur bzw. Sensorfläche 10 ist mittels der elektrisch leitfähigen Bahn 9 mit dem Elektronikmodul 18, genauer mit dem auf dem Zwischenträger 2 ausgebildeten dritten elektrischen Kontakt (dritten Kontaktpad) 6 elektrisch gekoppelt.

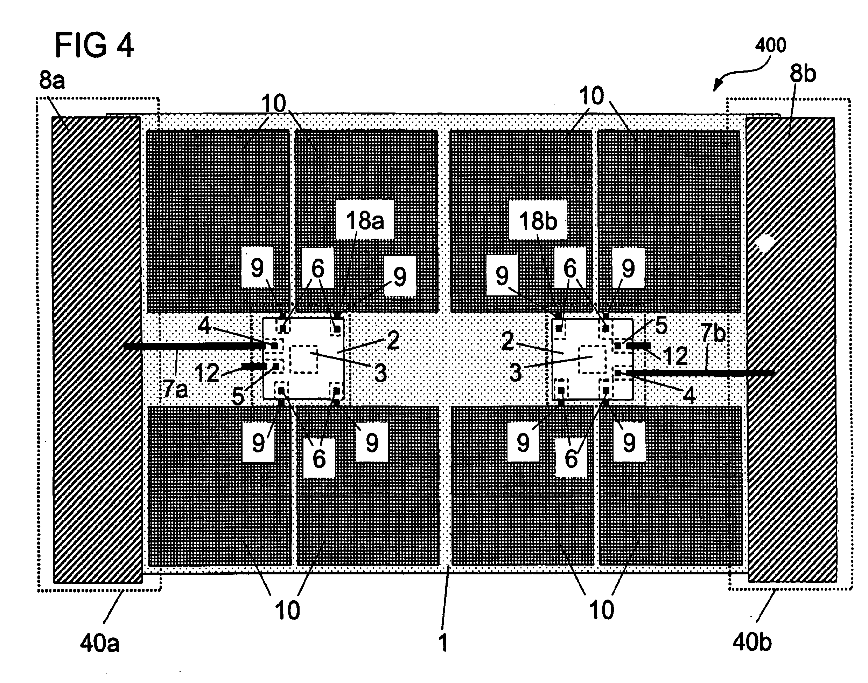

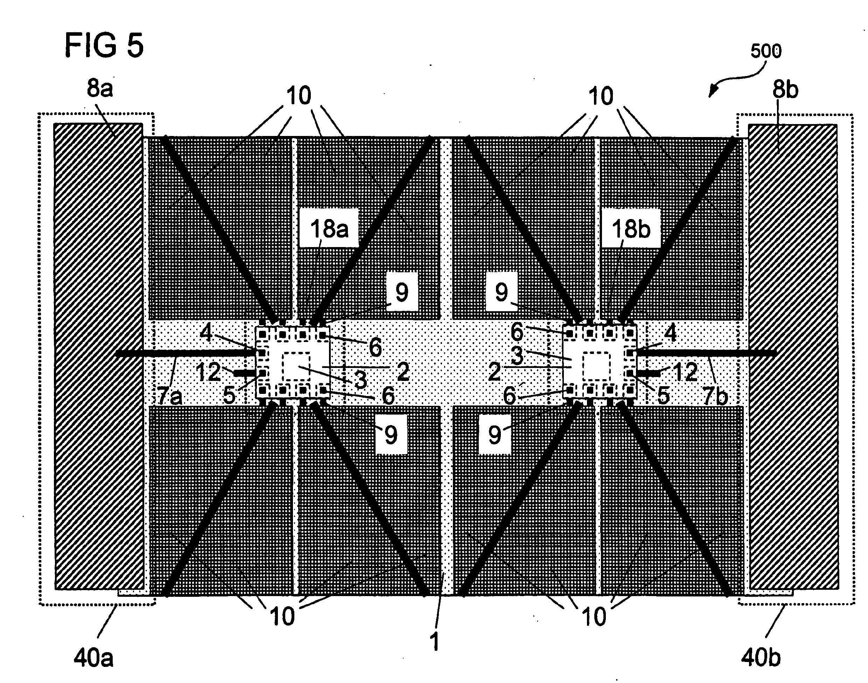

Das Elektronilanodul 18 der Textilschicht-Anordnung 100 kann alternativ mit mehreren Sensorflächen 10 elektrisch gekoppelt sein. Zum Beispiel können auf dem Zwischenträger 2 mehrere dritte elektrische Kontakte 6 (dritte Kontaktpads 6) ausgebildet sein, welche jeweils mittels einer elektrisch leitfähigen Bahn 9 mit der jeweiligen Sensorfläche 10 elektrisch verbunden sind (siehe zum Beispiel Fig.4 und Fig.5).

In diesem Zusammenhang ist anzumerken, dass die Anforderungen an die Leitfähigkeit der Sensorfläche 10 für den kapazitiven Sensor deutlich geringer sind als bei dem ersten elektrischen Kontakt 4 für die Versorgungsspannung bzw. dem zweiten elektrischen Kontakt 5 für Masse. Die Sensorfläche 10 kann daher beispielsweise unter Verwendung eines Carbon-Materials gedruckt werden oder kann alternativ aus Textil bestehend aus leitfähigen Polymeren gebildet werden.

Die Leiterbahnen und Leiterflächen für die Versorgungsspannung und Masse können aus metallisiertem Vlies oder Gewebe hergestellt werden. Alternativ können diese Flächen aufgedruckt werden, zum Beispiel mit metallgefülltem Kleber.

Die Textilschicht-Anordnung 100 weist ferner eine Kontakt-Struktur 12 auf, welche Kontakt-Struktur 12 unterhalb des zweiten Kontaktpads 5 in der ersten Textilschicht 1 und in der elektrisch leitfähigen Textilschicht 11 ausgebildet ist. Anschaulich bildet die Kontakt-Struktur 12 einen Durchkontakt zum elektrischen Kontaktieren des elektronischen Bauelementes 3 (bzw. des zweiten Kontaktpads 5) mit der elektrisch leitfähigen Schicht 11 (Masseleitung) durch die nicht-leitende erste Textilschicht 1 hindurch.

Der Durchkontakt 12 kann unter Verwendung von Metall-Filamenten gebildet werden, zum Beispiel mittels Verstickens leitfähiger Filamente (zum Beispiel Kupfer-Drähte, versilberte Kupfer-Drähte, Stahldrähte, Metalldrähte in Kombination mit Polyester-Filamenten bzw. Aramid-Garnen) oder alternativ mittels Vernietens oder Crimpens an der entsprechenden Stelle.

Das Kontaktieren des Zwischenträgers 2 kann mittels Klebens mit leitfähigem, nichtleitfähigem oder anisotrop leitfähigem Kleber erfolgen. Alternativ kann das Kontaktieren des Zwischenträgers 2 mittels Lötens, Laserschweißens oder Anstickens an die elektrischen Kontakte 4, 5, 6 erfolgen, weiter alternativ mittels eines Crimp-Verfahrens ("Crimpen").

Fig.1B zeigt die Textilschicht-Anordnung 100 während eines Prozessschrittes des Verfahrens nach dem Verbinden der Textilschichten 1 und 13. Das Verbinden der ersten Textilschicht 1 mit der zweiten Textilschicht 13 kann mittels eines Laminier-Verfahrens erfolgen. Das Anschlusstextil 8 bzw. die Anschluss-Textilschicht 8 für die Versorgungsspannung wird durch Umbiegen auf die Oberseite der Mehrlagenstruktur (d.h. die obere Oberfläche 13a der zweiten Textilschicht 13) geführt und kann mittels Klebens oder alternativ mittels Nähens mit nichtleitfähigem Garn 80 befestigt werden und bildet dort den Anschluss für die Versorgungsspannung. Durch die optionale Naht 80 kann gleichzeitig ein mechanischer Kantenschutz für das Textil erreicht werden, der es bei einer baustellenseitigen Installation und während des Gebrauchs schützt.

Dadurch, dass bei der Textilschicht-Anordnung 100 die Elektronik, die Sensorfläche(n) - und die entsprechende Verdrahtung zwischen der ersten Textilschicht 1 und der zweiten Textilschicht 13 ausgebildet sind, kann ein guter mechanischer Schutz der entsprechenden Komponenten erreicht werden.

**Fig.2** zeigt eine Draufsicht einer Textilschicht-Anordnung 200 gemäß einem zweiten Ausführungsbeispiel der Erfindung.
Die Darstellung entspricht im Wesentlichen einer Draufsicht auf die in Fig.1A gezeigte Textilschicht-Anordnung 100, wobei in Fig.2 die obere Textilschicht, d.h. die zweite Textilschicht 13, nicht dargestellt ist.

Gemäß dem in Fig.2 gezeigten Ausführungsbeispiel ist bei der Textilschicht-Anordnung 200 jeweils eine Sensorfläche pro Elektronik-Modul bzw. Netzwerkelement vorgesehen. In Fig.2 sind beispielhaft zwei Netzwerkelemente 18a und 18b und vier Sensorflächen 10a, 10a, 10b und 10b' gezeigt, wobei ein erstes Netzwerkelement 18a mit einer ersten Sensorfläche 10a elektrisch gekoppelt ist, und ein zweites Netzwerkelement 18b mit einer zweiten Sensorfläche 10b elektrisch gekoppelt ist. Eine dritte Sensorfläche 10b ist entsprechend mit einem (nicht gezeigten) dritten Netzwerkelement gekoppelt, und eine vierte Sensorfläche 10b' ist mit einem (nicht gezeigten) vierten Netzwerkelement gekoppelt. Die Textilschicht-Anordnung 200 weist eine erste Energieleitung 8a auf, welche erste Energieleitung 8a in einem ersten Randbereich 40a der Textilschicht-Anordnung 200 ausgebildet ist. Ferner weist die Textilschicht-Anordnung 200 eine zweite Energieleitung 8b auf, welche zweite Energieleitung 8b in einem zweiten Randbereich 40b der Textilschicht-Anordnung 200 ausgebildet ist. Das erste Netzwerkelement 18a ist mittels einer ersten Zuleitung 7a mit der ersten Energieleitung 8a elektrisch gekoppelt, und das zweite Netzwerkelement 18b ist mittels einer zweiten Zuleitung 7b mit der zweiten Energieleitung 8b elektrisch gekoppelt. Bei der Textilschicht-Anordnung 200 gemäß dem gezeigten Ausführungsbeispiel sind die erste Zuleitung 7a und die erste Energieleitung 8a in einem rechten Winkel, d.h. unter einem Winkel von 90°, zueinander angeordnet. Ferner sind die zweite Zuleitung 7b und die zweite Energieleitung 8b ebenfalls unter einem Winkel von 90° zueinander angeordnet. Gemäß alternativen Ausführungsbeispielen der Erfindung können/kann der Winkel zwischen der ersten Zuleitung 7a und der ersten Energieleitung 8a und/oder der Winkel zwischen der zweiten Zuleitung 7b und der zweiten Energieleitung 8b einen anderen (von 0° bzw. 180° verschiedenen) Wert aufweisen. Anschaulich ist an jeder Kante der Textilschicht-Anordnung 200 bzw. des Textils jeweils eine Energieleitung 8a, 8b ausgebildet, wobei die Energieleitungen 8a, 8b mit einer Versorgungsspannung elektrisch koppelbar sind zum Bereitstellen elektrischer Energie an den Netzwerkelementen 18a, 18b. Mit anderen Worten wird das erste Netzwerkelement 18a (bzw. die in dem ersten Netzwerkelement 18a ausgebildeten elektronischen Bauelemente 3) mittels der ersten Energieleitung 8a mit elektrischer Energie versorgt, und das zweite Netzwerkelement 18b (bzw. die in dem zweiten Netzwerkelement 18b ausgebildeten elektronischen Bauelemente 3) wird mittels der zweiten Energieleitung 8b mit elektrischer Energie versorgt. Das (nicht gezeigte) dritte Netzwerkelement, welches mit der dritten Sensorfläche 10a' gekoppelt ist, kann mittels einer dritten Zuleitung (nicht gezeigt) mit der ersten Energieleitung 8a gekoppelt sein und von dieser mit elektrischer Energie versorgt werden, und das (nicht gezeigte) vierte Netzwerkelement, welches mit der vierten Sensorfläche 10b' gekoppelt ist, kann mittels einer vierten Zuleitung (nicht gezeigt) mit der zweiten Energieleitung 8b gekoppelt sein und von dieser mit elektrischer Energie versorgt werden. Die erste Energieleitung 8a und die zweite Energieleitung 8b sind jeweils als elektrisch leitfähiges Textilband ausgebildet.

Mittels mehrfachen Aneinanderlegens der in Fig.2 gezeigten Textilschicht-Anordnung 200 (welche auch als Textilbahn bezeichnet werden kann) kann ein Textilschicht-Array gebildet werden, wobei in dem Textilschicht-Array die Energieleitungen 8a, 8b der einzelnen Textilbahnen 200 miteinander gekoppelt sind. In diesem Zusammenhang ist anzumerken, dass aufgrund der Symmetrie der in Fig.2 gezeigten Textilschicht-Anordnung 200 zwei Textilbahnen 200 sowohl so aneinandergefügt werden können, dass jeweils zwei erste Energieleitungen 8a miteinander gekoppelt sind und zwei zweite Energieleitungen 8b miteinander gekoppelt sind, als auch so, dass eine erste Energieleitung 8a der einen Textilbahn mit einer zweiten Energieleitung 8b der anderen Textilbahn gekoppelt ist und umgekehrt. Mit anderen Worten können beim Aneinanderfügen mehrerer Textilbahnen 200 eine oder mehrere der Textilbahnen 200 um 180 Grad gedreht sein. Anschaulich kann die in Fig.2 gezeigte Struktur nach oben bzw. unten, d.h. in Richtung der Längsachse der Energieleitungen 8a, 8b, durch Aneinanderfügen einzelner Textilbahnen periodisch fortgesetzt werden. Alternativ oder zusätzlich kann die in Fig.2 gezeigte Struktur nach links bzw. rechts, d.h. senkrecht zur Längsachse der Energieleitungen 8a, 8b, durch Aneinanderfügen einzelner Textilbahnen periodisch fortgesetzt werden. Mittels. Aneinanderlegens einzelner Textilbahnen zu einem Textilschicht-Array kann somit eine beliebig große Fläche mit Textilbahnen abgedeckt werden.

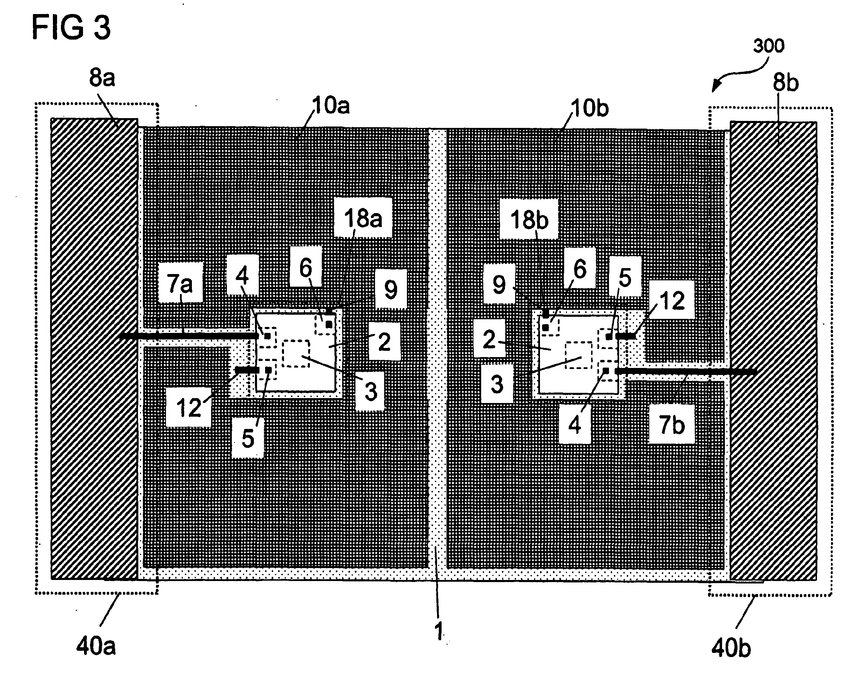

**Fig.3** zeigt eine Draufsicht einer Textilschicht-Anordnung 300 gemäß einem dritten Ausführungsbeispiel der Erfindung, bei der wie bei der Textilschicht-Anordnung 200 jedes Netzwerkelement an eine Sensorfläche angeschlossen ist. Im Unterschied zu der in Fig.2 gezeigten Textilschicht-Anordnung 200 ist jedoch bei der Textilschicht-Anordnung 300 die Sensorfläche fast vollständig bis auf den Anschluss für die Versorgungsspannung um das jeweilige Elektronikmodul herumgeführt. Beispielhaft sind ein erstes Netzwerkelement 18a und ein zweites Netzwerkelement 18b sowie eine erste Sensorfläche 10a und eine zweite Sensorfläche 10b gezeigt, wobei das erste Netzwerkelement 18a mit der ersten Sensorfläche 10a elektrisch gekoppelt ist, und das zweite Netzwerkelement 18b mit der zweiten Sensorfläche 10b elektrisch gekoppelt ist. Eine erste Zuleitung 7a koppelt das erste Netzwerkelement 18a (bzw. eines oder mehrere in dem ersten Netzwerkelement 18a ausgebildete elektronische Bauelemente 3) mit einer in einem ersten Randbereich 40a der Textilschicht-Anordnung 300 ausgebildeten ersten Energieleitung 8a, und eine zweite Zuleitung 7b koppelt entsprechend das zweite Netzwerkelement 18b (bzw. eines oder mehrere in dem zweiten Netzwerkelement 18b ausgebildete elektronische Bauelemente 3) mit einer in einem zweiten Randbereich 40b der Textilschicht-Anordnung 300 ausgebildeten zweiten Energieleitung 8b.

**Fig.4** zeigt eine Textilschicht-Anordnung 400 gemäß einem vierten Ausführungsbeispiel der Erfindung. Die Textilschicht-Anordnung 400 unterscheidet sich von der in Fig.2 gezeigten Textilschicht-Anordnung 200 dadurch, dass an das erste Netzwerkelement 18a und an das zweite Netzwerkelement 18b jeweils vier Sensorflächen 10 angeschlossen sind. Der Zwischenträger 2 des jeweiligen Netzwerkelementes bzw. Elektronikmoduls weist dazu vier dritte elektrische Kontakte bzw. Kontaktpads 6 auf für die Sensoren 10. Die Elektronik 3 kann so eingerichtet sein, dass ein Multiplexen der Sensoren 10 (bzw. der Sensor-Signale) möglich ist.

**Fig.5** zeigt eine Textilschicht-Anordnung 500 gemäß einem fünften Ausführungsbeispiel der Erfindung, bei der acht Sensoren bzw. Sensorflächen 10 pro Netzwerkmodul 18a, 18b vorgesehen sind. Gemäß dem gezeigten Ausfsührungsbeispiel weisen die Sensorflächen 10 eine dreieckige Form auf, um ein einfaches Anschließen der dritten Kontaktpads 6 mittels der elektrisch leitfähigen Bahnen 9 (Verbindungsbahnen) an die Sensorflächen 10 zu erreichen.

In den in Fig.3 bis Fig.5 gezeigten Ausführungsbeispielen sind jeweils zwei Elektronik-Module (Netzwerk-Module bzw. Netzwerk-Elemente) in einem Abstand nebeneinander (d.h. in einer Reihe) ausgebildet (in Fig.3 bis Fig.5 sind repräsentativ ein erstes Netzwerkelement 18a und ein zweites Netzwerkelement 18b dargestellt), wobei eines der beiden Netzwerkelemente mit der ersten Energieleitung 8a elektrisch gekoppelt ist, und das andere Netzwerkelement mit der zweiten Energieleitung 8b elektrisch gekoppelt ist.

In alternativen Ausgestaltungen der Erfindung können mehr als zwei Module pro Reine in die Mehrlagen-Struktur einer Textilschicht-Anordnung bzw. Textilbahn integriert sein. Ferner kann eine zusätzliche Energieleitung in der Mitte der Textilbahn eingeführt werden, welche zusätzliche Energieleitung mit der Versorgungsspannung gekoppelt werden kann. Bei einem sehr dichten Raster von Netzwerkmodulen kann die Versorgungsspannung durch alle Module durchgeschleift werden.

Eine in der Mitte einer Textilbahn ausgebildete zusätzliche Energieleitung kann alternativ mit einem niedrigen elektrischen Potential (zum Beispiel dem elektrischen Masse-Potential) gekoppelt sein, und die in der Textilbahn bzw. Textilschicht-Anordnung ausgebildeten Netzwerkelemente können (zum Beispiel mittels elektrisch leitfähiger Bahnen) mit der, in diesem Fall anschaulich als Masseleitung dienenden, zusätzlichen Energieleitung elektrisch gekoppelt sein.

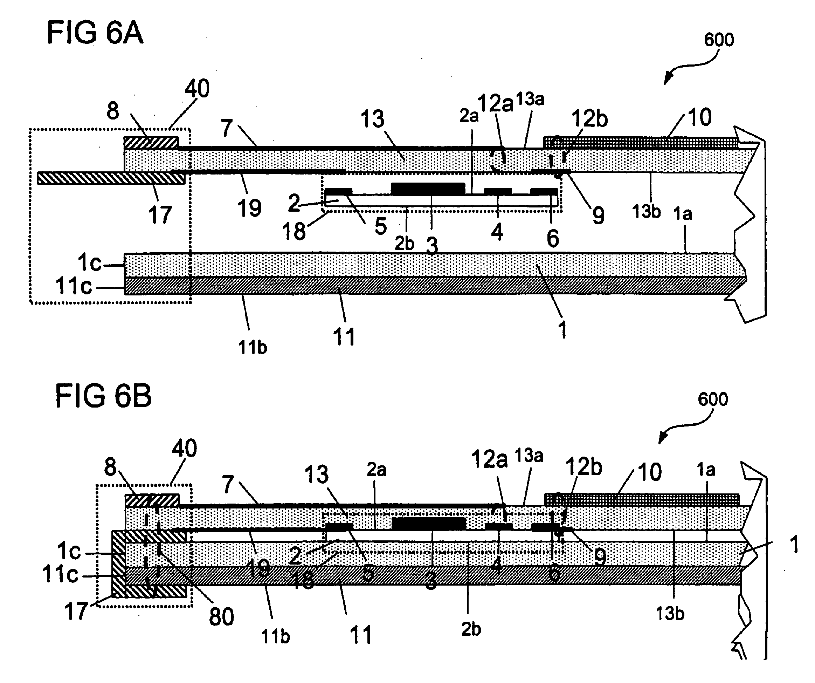

**Fig.6A** und **Fig.6B** zeigen jeweils eine Teilquerschnittsansicht einer Textilschicht-Anordnung 600 gemäß einem sechsten Ausführungsbeispiel der Erfindung, wobei Fig.6A die Textilschicht-Anordnung 600 vor einem Verbinden der ersten Textilschicht 1 mit der zweiten Textilschicht 13 zeigt, und Fig.6B die Textilschicht-Anordnung 600 nach dem Verbinden der beiden Textilschichten 1 und 13 zeigt, wobei die erste Textilschicht 1 und die zweite Textilschicht 13 mittels eines Laminier-Verfahrens miteinander verbunden werden.

Die Textilschicht-Anordnung 600 unterscheidet sich von den vorangehend beschriebenen Textilschicht-Anordnungen im wesentlichen dadurch, dass das nichtleitflähige Textil 13 (die nicht-leitfähige zweite Textilschicht 13) als Grundlage für die Verdrahtung der Elektronik 3 dient. Das Elektronik-Modul 18 bzw. der Zwischenträger 2 des Elektronik-Moduls 18 wird so angeordnet, dass die zweite Hauptoberfläche 2b des Zwischenträgers 2 eine gemeinsame Grenzfläche mit der oberen Oberfläche 1a der ersten Textilschicht 1 aufweist. Der Zwischenträger 2 mit der Elektronik 3 ist auf der unteren Oberfläche 13b der zweiten Textilschicht 13, mit anderen Worten auf der Unterseite 13b des nichtleitfähigen Textils 13, verdrahtet. Die Sensorflächen 10, die Energieleitung 8 (d.h. der Anschluss zu der Versorgungsspannung) und die Zuleitung 7, welche das bzw. die auf dem Zwischenträger 2 ausgebildeten elektronischen Bauelemente 3 mit der Energieleitung 8 elektrisch koppelt, sind auf der Oberseite der Mehrlagenshuktur, mit anderen Worten auf der oberen Oberfläche 13a der zweiten Textilschicht 13 ausgebildet. Dadurch wird erreicht, dass der Abstand zur elektrisch leitfähigen Schicht 11 (bzw. Masseabschirmung 11) größer und gleichzeitig der Abstand zur Oberfläche des Bodenbelags kleiner wird. Die Grundkapazität des kapazitiven Sensors kann somit verringert werden, wodurch ein zu detektierendes Signal einer Kapazitäts-Änderung durch Begehen des Bodenbelags vergrößert werden kann.

Der erste elektrische Kontakt 4 (erstes Kontaktpad 4 für die Versorgungsspannung) ist mittels einer ersten Kontakt-Struktur 12a (erster Durchkontakt 12a), welche erste Kontakt-Struktur 12a in der zweiten Textilschicht 13 ausgebildet ist, mit der Zuleitung 7 elektrisch verbunden. Ferner ist der dritte elektrische Kontakt 6 (drittes Kontaktpad 6 für den Sensoranschluss) mittels einer zweiten Kontakt-Struktur 12b (zweiter Durchkontakt 12b), welche zweite Kontakt-Struktur 12b in der zweiten Textilschicht 13 ausgebildet ist, mit der Sensorfläche 10 elektrisch verbunden. Anschaulich wird das erste Kontaktpad 4 mittels Durchkontaktierens durch die zweite Textilschicht 13 hindurch mit der auf der oberen Oberfläche 13a der zweiten Textilschicht 13 ausgebildeten Zuleitung 7 elektrisch gekoppelt, und das dritte Kontaktpad 6 wird entsprechend mittels Durchkontaktierens mit der Sensorfläche 10 elektrisch gekoppelt. Das Durchkontaktieren bzw. das Ausbilden der Kontakt-Strukturen 12a, 12b kann in analoger Weise erfolgen wie im Zusammenhang mit Fig.1A bzw. Fig.1B für den Durchkontakt 12 beschrieben wurde.

Der zweite elektrische Kontakt 5 (zweites Kontaktpad 5 für Masse-Anschluss) ist mit einer auf der unteren Oberfläche 13b (anschaulich der Unterseite) der zweiten Textilschicht 13 ausgebildeten zweiten elektrisch leitfähigen Bahn 19 elektrisch verbunden. Die zweite elektrisch leitfähige Bahn 19 ist mit einem elektrisch leitfähigen Textil 17 verbunden, welches in dem Randbereich 40 der Textilschicht-Anordnung 600 auf die untere Oberfläche 13b der zweiten Textilschicht 13 aufgebracht wird (siehe Fig.6A) und nach dem Verbinden der ersten Textilschicht 1 mit der zweiten Textilschicht 13 um die erste Textilschicht 1 und die elektrisch leitfähige Schicht 11 herumgeführt wird (siehe Fig.6B), so dass das elektrisch leitfähige Textil 17 einen in dem Randbereich 40 der Textilschicht-Anordnung 600 ausgebildeten Endabschnitt der ersten Textilschicht 1 und der elektrisch leitfähigen Schicht 11 umschließt, wobei ein erster Teilbereich des elektrisch leitfähigen Textils 17 zwischen der ersten Textilschicht 1 und der zweiten Textilschicht 13 ausgebildet ist, ein zweiter Teilbereich des elektrisch leitfähigen Textils 17 auf der Kante 1c der ersten Textilschicht 1 und auf der Kante 11c der elektrisch leitfähigen Schicht 11 ausgebildet ist, und ein dritter Teilbereich des elektrisch leitfähigen Textils 17 auf einer unteren Oberfläche 11b (mit anderen Worten auf der Unterseite 11b) der elektrisch leitfähigen Schicht 11 ausgebildet ist. Anschaulich wird mittels des Textils 17 ein Kontakt der zweiten elektrisch leitfähigen Bahn 19 zur Masseleitung 11 gebildet, so dass ebenfalls das zweite Kontaktpad 5 des Netzwerkmoduls 18 mit der Masseleitung 11 elektrisch kontaktiert ist.

Fig.6B zeigt die Textilschicht-Anordnung 600 im laminierten Zustand. Das leitfähige Textil 17, welches (zusammen mit der zweiten elektrisch leitfähige Bahn 19) die Masse 11 mit dem Netzwerkmodul 18 verbindet, ist um die nichtleitfähige Textillage 1 (erste Textilschicht 1) und die elektrisch leitfähige Schicht 11 (zum Beispiel leitfähiges Textil 11) herumgeführt und kontaktiert auf diese Weise die Abschirmfläche mit dem Netzwerkmodul 18. In analoger Weise wie im Zusammenhang mit Fig.1B beschrieben, können/kann mittels Nähens mit nichtleitfähigem Garn 80 die Energieleitung 8 und/oder das leitfähige Textil 17 befestigt werden. Mittels der optionalen Naht 80 kann wiederum zusätzlich ein mechanischer Kantenschutz für das Textil erreicht werden.

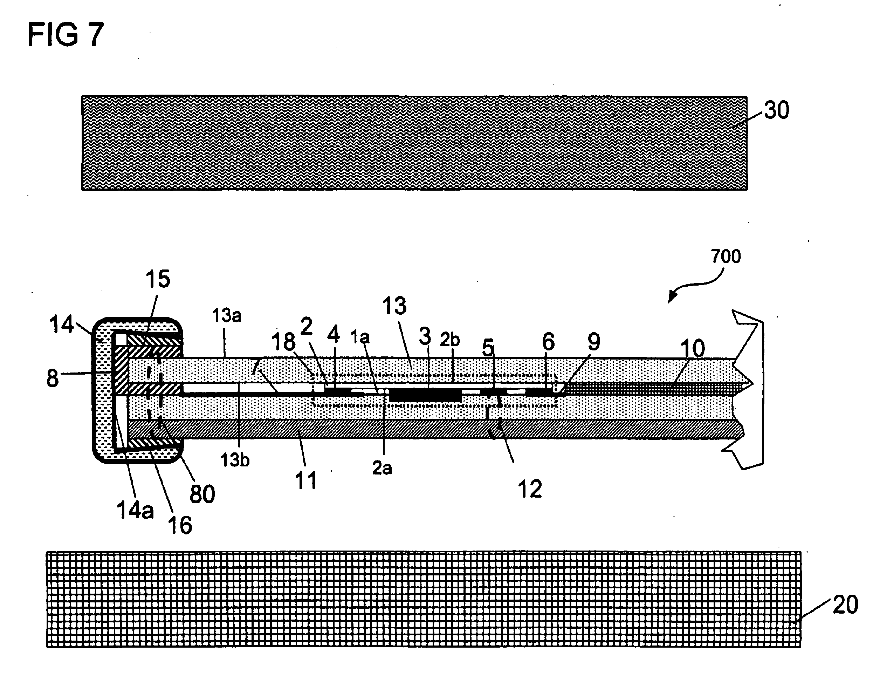

**Fig.7** zeigt eine Textilschichtanordnung 700 gemäß einem siebten Ausführungsbeispiel der Erfindung. Die Textilschichtanordnung 700 unterscheidet sich von der in Fig.1B gezeigten Textilschicht-Anordnung 100 dadurch, dass die Textilschichtanordnung 700 zusätzlich eine Klemmschiene 14 aufweist, welche Klemmschiene 14 den Randbereich 40 (vgl. Fig. 1B) der Textilschicht-Anordnung 700 umschließt. Die Klemmschiene 14 dient zum elektrischen Kontaktieren der Energieleitung 8 bzw. der elektrisch leitfähigen Anschluss-Textilschicht 8.

Mit anderen Worten kann mittels der Klemmschiene 14 ein Anschluss der textilen Mehrlagenstruktur bzw. der Textilschicht-Anordnung 700 an die Stromversorgung erreicht werden. Die Klemmschiene 14 kann aus einem elektrisch nichtleitfähigen Material (zum Beispiel Kunststoff), alternativ aus einem elektrisch leitfähigen Material mit einem elektrisch isolierenden Überzug, ausgebildet sein. Die Klemmschiene 14 weist auf einer Innenseite 14a eine erste leitfähige Beschichtung 15 auf, welche erste leitfähige Beschichtung 15 als erster Kontakt der Klemmleiste dient und auf der Oberseite das elektrisch leitfähige Textil 8 (Energieleitung 8) elektrisch kontaktiert. Ferner weist die Klemmschiene 14 auf der Innenseite 14a eine zweite leitfähige Beschichtung 16 auf, welche zweite leitfähige Beschichtung 16 als zweiter Kontakt der Klemmleiste 14 dient und auf der Unterseite das leitfähige Textil 11 (Masseleitung 11) elektrisch kontaktiert. Die Klemmschiene 14 kann so ausgebildet sein, dass sie gegenüber der elastischen textilen Mehrlagenstruktur eine federnde Verbindung herstellt. Werden mehrere Textilbahnen nebeneinander gelegt (bzw. zu einer Fläche zusammengefügt), können sie beispielsweise an der Stirnseite mittels Anbringens einer durchgehenden Klemmleiste 14 elektrisch miteinander verbunden werden, alternativ mittels Verklebens mit leitfähigem Kleber oder mittels leitfähigen Klebebands.

Die Textilbahnen können, wie in Fig.7 gezeigt, direkt auf einem Untergrund 20 (zum Beispiel einem Estrich) aufgebracht bzw. montiert werden. Ferner können die Bahnen, wie in Fig.7 gezeigt, mit einem handelsüblichen Bodenbelag 30 (zum Beispiel Kunststoffboden, Gummiboden, Laminat, Parkett, Fliesen, Steinbelag oder andere geeignete Bodenbeläge) abgedeckt werden. Bei einer Abdeckung mit Fliesen oder einem Steinbelag kann eine weitere Zwischenschicht wie zum Beispiel Watec®2E eingefügt werden. Diese Zwischenschicht bildet ein armiertes Tragesystem für im Dünnbett verlegte keramische Fliesen im Innenbereich und dient zur Entlüftung sowie zur Entkopplung des Belags vom Untergrund.

In diesem Dokument sind folgende Veröffentlichungen zitiert:
[1] http://www.vorwerk-teppich.de/sc/vorwerk/img/ thinking_carpet.doc
[2] DE 103 44 285 A1
[3] DE 10 2004 001 661 A1
[4] DE 103 07 505 A1

### Bezugszeichenliste

- 1: erste Textilschicht
- 1a: obere Oberfläche der ersten Textilschicht
- 1c: Kante
- 2: Zwischenträger
- 2a: erste Hauptoberfläche
- 2b: zweite Hauptoberfläche
- 3: elektronisches Bauelement
- 4: erster elektrischer Kontakt
- 5: zweiter elektrischer Kontakt
- 6: dritter elektrischer Kontakt
- 7: Zuleitung
- 7a: erste Zuleitung
- 7b: zweite Zuleitung
- 8: Energieleitung
- 8a: erste Energieleitung
- 8b: zweite Energieleitung
- 9: elektrisch leitfähige Bahn
- 10: Sensorfläche
- 10a: erste Sensorfläche
- 10b: zweite Sensorfläche
- 10a': dritte Sensorfläche
- 10b': vierte Sensorfläche
- 11: elektrisch leitfähige Schicht
- 11b: untere Oberfläche der elektrisch leitfähigen Schicht
- 11c: Kante
- 12: Kontakt-Struktur
- 12a: erste Kontakt-Struktur
- 12b: zweite Kontakt-Struktur
- 13: zweite Textilschicht
- 13a: obere Oberfläche der zweiten Textilschicht
- 13b: untere Oberfläche der zweiten Textilschicht
- 14: Klemmleiste
- 14a: Innenseite der Klemmleiste
- 15: erster Kontakt der Klemmleiste
- 16: zweiter Kontakt der Klemmleiste
- 17: elektrisch leitfähiges Textil
- 18: Elektronik-Modul
- 18a: erstes Netzwerkelement
- 18b: zweites Netzwerkelement
- 19: zweite elektrisch leitfähige Bahn
- 20: Untergrund
- 30: Bodenbelag
- 40: Randbereich
- 40a: erster Randbereich
- 40b: zweiter Randbereich
- 80: Nichtleitfähige Naht

- 100, 200,:
- 300, 400,:
- 500, 600,:
- 700: Textilschicht-Anordnungen

## Patentansprüche

1. Textilschicht-Anordnung (100),
• mit einer ersten Textilschicht (1);
• mit einer zweiten Textilschicht (13), wobei die zweite Textilschicht (13) auf oder über der ersten Textilschicht (1) ausgebildet ist;
• mit einem Elektronikmodul (18) mit mindestens einem elektronischen Bauelement (18a, 18b), welches zwischen der ersten Textilschicht (1) und der zweiten Textilschicht (13) ausgebildet ist;
• mit mindestens einer als Sensorelement (10, 10a, 10b) ausgebildeten elektrisch leitfähigen Struktur, welche zwischen der ersten Textilschicht (1) und der zweiten Textilschicht (13) ausgebildet ist, wobei das Sensorelement (10, 10a, 10b) mit dem Elektronikmodul (18) verbunden ist;
• mit einer elektrisch leitfähigen Schicht (11), wobei die erste Textilschicht (1) auf der elektrisch leitfähigen Schicht (11) ausgebildet ist; wobei das mindestens eine elektronische Bauelement (18a, 18b) mit der elektrisch leitfähigen Schicht (11) elektrisch gekoppelt ist; und
**dadurch gekennzeichnet, dass** die Textilschicht-Anordnung (100)
• mindestens eine in mindestens einem Randbereich (40, 40a, 40b) entlang einer Kante (1c) der Textilschicht-Anordnung (100) ausgebildete Energieleitung (8) zum Bereitstellen elektrischer Energie; und
• mindestens eine Zuleitung (7), welche das mindestens eine elektronische Bauelement (18a, 18b) mit der mindestens einen Energieleitung (8) elektrisch koppelt;
aufweist, und
• wobei die mindestens eine Energieleitung (8) in einem Abstand zu dem mindestens einen elektronischen Bauelement (18a, 18b) angeordnet ist; und
• wobei die mindestens eine Zuleitung (7) in einem Winkel zu der mindestens einen Energieleitung (8) angeordnet ist.

2. Textilschicht-Anordnung (100) gemäß Anspruch 1, wobei die erste Textilschicht (1) und/oder die zweite Textilschicht (13) als elektrisch nicht-leitende Textilschicht ausgebildet ist.

3. Textilschicht-Anordnung (100) gemäß einem der Ansprüche 1 oder 2 wobei das Elektronikmodul (18) mindestens einen Zwischenträger (2) aufweist , wobei das mindestens eine elektronische Bauelement (18a, 18b) auf einer ersten Hauptoberfläche des mindestens einen Zwischenträgers ausgebildet ist, und wobei eine der ersten Hauptoberfläche gegenüberliegende zweite Hauptoberfläche des mindestens einen Zwischenträgers eine gemeinsame Grenzfläche aufweist mit einer oberen Oberfläche der ersten Textilschicht (1) oder mit einer unteren Oberfläche der zweiten Textilschicht (13).

4. Textilschicht-Anordnung (100) gemäß einem der Ansprüche 1 bis 3, wobei das mindestens eine elektronische Bauelement (18a, 18b) als integrierter Schaltkreis ausgebildet ist.

5. Textilschicht-Anordnung (100) gemäß einem der Ansprüche 1 bis 4, wobei das mindestens eine elektronische Bauelement (18a, 18b) mindestens ein Sende-/Empfangs-Element aufweist.

6. Textilschicht-Anordnung (100) gemäß einem der Ansprüche 1 bis 5, wobei die mindestens eine Energieleitung (8) mindestens eine elektrisch leitfähige Anschluss-Textilschicht aufweist.

7. Textilschicht-Anordnung (100) gemäß Anspruch 6, wobei die mindestens eine elektrisch leitfähige Anschluss-Textilschicht so ausgebildet ist, dass sie einen in dem mindestens einen Randbereich (40, 40a, 40b) der Textilschicht-Anordnung (100) ausgebildeten Endabschnitt der zweiten Textilschicht (13) umschließt.

8. Textilschicht-Anordnung (100) gemäß Anspruch 7, mit mindestens einer Klemmschiene (14) zum elektrischen Kontaktieren der mindestens einen elektrisch leitfähigen Anschluss-Textilschicht, welche mindestens eine Klemmschiene (14) den mindestens einen Randbereich (40, 40a, 40b) der Textilschicht-Anordnung (100) umschließt.

9. Textilschicht-Array, mit einer Mehrzahl von Textilschicht-Anordnungen (100) gemäß einem der Ansprüche 1 bis 8, welche mittels der mindestens einen Energieleitung (8) miteinander gekoppelt sind.

10. Verfahren zum Herstellen einer Textilschicht-Anordnung (100), bei dem
● ein Elektronikmodul (18) mit mindestens einem einemelektronischen Bauelement (18a, 18b) auf einer ersten Textilschicht (1) angeordnet wird;
● eine zweite Textilschicht (13) auf der ersten Textilschicht (1) und auf dem mindestens einen elektronischen Bauelement (18a, 18b) gebildet wird;
● mindestens eine als Sensorelement (10, 10a, 10b) ausgebildete elektrisch leitfähige Struktur zwischen der ersten Textilschicht (1) und der zweiten Textilschicht (13) gebildet wird, wobei das Sensorelement (10, 10a, 10b) mit dem Elektronikmodul (18) verbunden wird;
● eine elektrisch leitfähige Schicht (11) gebildet wird, wobei die erste Textilschicht (1) auf der elektrisch leitfähigen Schicht (11) gebildet wird; wobei das mindestens eine elektronische Bauelement (18a, 18b) mit der elektrisch leitfähigen Schicht (11) elektrisch gekoppelt wird; und
**dadurch gekennzeichnet, dass**
● mindestens eine Energieleitung (8) zum Bereitstellen elektrischer Energie in mindestens einem Randbereich (40, 40a, 40b) entlang einer Kante (1c) der Textilschicht-Anordnung gebildet wird;
● mindestens eine Zuleitung (7) von dem mindestens einen elektronischen Bauelement (18a, 18b) zu dem mindestens einen Randbereich (40, 40a, 40b) der TextilschichtAnordnung (100) hin gebildet wird; und
● mittels der mindestens einen Zuleitung (7) die mindestens eine Energieleitung (8) in einem Winkel zu der mindestens einen Zuleitung (7) und in einem Abstand zu dem mindestens einen elektronischen Bauelement (18a, 18b) in dem Randbereich (40, 40a, 40b) der Textilschicht-Anordnung elektrisch kontaktiert wird.

11. Verfahren gemäß Anspruch 10, wobei die erste Textilschicht (1) und/oder die zweite Textilschicht (13) als elektrisch nicht-leitende Textilschicht gebildet werden.

12. Verfahren gemäß einem der Ansprüche 10 oder 11, wobei das mindestens eine elektronische Bauelement (18a, 18b) mittels elektrischen Durchkontaktierens durch die erste Textilschicht (1) hindurch mit der elektrisch leitfähigen Schicht (11) elektrisch gekoppelt wird.

13. Verfahren gemäß Anspruch 12; wobei das Durchkontaktieren unter Verwendung eines oder mehrerer der folgenden Verfahren erfolgt:
• ein Verfahren zum Versticken elektrisch leitfähiger Filamente;
• ein Verfahren zum Vernieten;
• ein Crimp-Verfahren.

14. Verfahren gemäß einem der Ansprüche 10 bis 13, wobei die erste Textilschicht (1) und die zweite Textilschicht (13) unter Verwendung eines Laminier-Verfahrens miteinander verbunden werden.

## Claims

1. A textile layer arrangement (100), comprising:
• a first textile layer (1);
• a second textile layer (13), wherein the second textile layer (13) is formed on or above the first textile layer (1);
• an electronic module (18) having at least one electronic component (18a, 18b), which is formed between the first textile layer (1) and the second textile layer (13);
• at least one electrically conductive structure configured as a sensor element (10, 10a, 10b), which is formed between the first textile layer (1) and the second textile layer (13), wherein the sensor element (10, 10a, 10b) is connected with the electronic module (18);
• an electrically conductive layer (11), wherein the first textile layer (1) is formed on the electrically conductive layer (11); wherein the at least one electronic component (18a, 18b) is electrically coupled with the electrically conductive layer (11); and **characterized in that** the textile layer arrangement (100) comprises
• at least one energy line (8) formed in at least one peripheral region (40, 40a, 40b) along an edge (1c) of the textile layer arrangement (100), for providing electrical energy; and
• at least one supply line (7), which electrically couples the at least one electronic component (18a, 18b) with the at least one energy line (8);
and
• wherein the at least one energy line (8) is at a distance to the at least one electronic component (18a, 18b); and
• wherein the at least one supply line (7) is arranged at an angle to the at least one energy line (8).

2. The textile layer arrangement (100) according to claim 1, wherein the first textile layer (1) and/or the second textile layer (13) is configured as electrically non-conductive textile layer.

3. The textile layer arrangement (100) according to one of claims 1 or 2, wherein the electronic module (18) comprises at least one interposer (2), wherein the at least one electronic component (18a, 18b) is formed on a first main surface of the at least one interposer, and wherein a second main surface of the at least one interposer opposing the first main surface comprises a common interface with an upper surface of the first textile layer (1) or with a lower surface of the second textile layer (13).

4. The textile layer arrangement (100) according to one of claims 1 to 3, wherein the at least one electronic component (18a, 18b) is configured as integrated circuit.

5. The textile layer arrangement (100) according to one of claims 1 to 4, wherein the at least one electronic component (18a, 18b) comprises at least one send-receive element.

6. The textile layer arrangement (100) according to one of claims 1 to 5, wherein the at least one energy line (8) comprises at least one electrically conductive contact textile layer.

7. The textile layer arrangement (100) according to claim 6, wherein the at least one electrically conductive contact textile layer is configured such that it encloses an end section of the second textile layer (13) formed in the at least one peripheral region (40, 40a, 40b) of the textile layer arrangement (100).

8. The textile layer arrangement (100) according to claim 7, comprising at least one clamping rail (14) for electrically contacting the at least one electrically conductive contact textile layer, which at least one clamping rail (14) encloses the at least one peripheral region (40, 40a, 40b) of the textile layer arrangement (100).

9. A textile layer array, comprising a plurality of textile layer arrangements (100) according to one of claims 1 to 8, which are coupled with each other by means of the at least one energy line (8).

10. A method for fabricating a textile layer arrangement (100), in which
• an electronic module (18) having at least one electronic component (18a, 18b) is arranged on a first textile layer (1);
• a second textile layer (13) is formed on the first textile layer (1) and on the at least one electronic component (18a, 18b);
• at least one electrically conductive structure configured as a sensor element (10, 10a, 10b is formed between the first textile layer (1) and the second textile layer (13), wherein the sensor element (10, 10a, 10b) is connected with the electronic module (18);
• an electrically conductive layer (11) is formed, wherein the first textile layer (1) is formed on the electrically conductive layer (11); wherein the at least one electronic component (18a, 18b) is electrically coupled with the electrically conductive layer (11); and
**characterized in that**
• at least one energy line (8) is formed in at least one peripheral region (40, 40a, 40b) along an edge (1c) of the textile layer arrangement, for providing electrical energy;
• at least one supply line (7) is formed from the at least one electronic component (18a, 18b) towards the at least one peripheral region (40, 40a, 40b) of the textile layer arrangement (100); and
• by means of the at least one supply line (7), the at least one energy line (8) is electrically contacted in the peripheral region (40, 40a, 40b) of the textile layer arrangement at an angle to the at least one supply line (7) and at a distance to the at least one electronic component (18a, 18b).

11. The method according to claim 10, wherein the first textile layer (1) and/or the second textile layer (13) are formed as electrically non-conductive textile layer.

12. The method according to one of claims 10 or 11, wherein the at least one electronic component (18a, 18b) is electrically coupled with the electrically conductive layer (11) by means of electrical through-contacting through the first textile layer (1).

13. The method according to claim 12, wherein the through-contacting is carried out using one or more of the following methods:
• a method for stitching electrically conductive filaments;
• a method for riveting;
• a crimp method.

14. The method according to one of claims 10 to 13, wherein the first textile layer (1) and the second textile layer (13) are bonded to each other using a lamination method.

## Revendications

1. Structure de couches textiles (100),
- avec une première couche textile (1) ;
- avec une deuxième couche textile (13), la deuxième couche textile (13) étant réalisée sur ou au-dessus de la première couche textile (1) ;
- avec un module électronique (18) avec au moins un composant électronique (18a, 18b), qui est réalisé entre la première couche textile (1) et la deuxième couche textile (13) ;
- avec au moins une structure électroconductrice réalisée sous la forme d'un élément capteur (10, 10a, 10b), qui est réalisée entre la première couche textile (1) et la deuxième couche textile (13), l'élément capteur (10, 10a, 10b) étant relié au module électronique (18) ;
- avec une couche électroconductrice (11), la première couche textile (1) étant réalisée sur la couche électroconductrice (11) ; ledit au moins un composant électronique (18a, 18b) étant couplé électriquement avec la couche électroconductrice (11) ; et
**caractérisée en ce que** la structure de couches textiles (100) comporte
- au moins une ligne d'énergie (8), réalisée dans au moins une zone de lisière (40, 40a, 40b) le long d'un bord (1c) de la structure de couches textiles (100) et destinée à fournir l'énergie électrique ; et
- au moins une ligne d'acheminement (7) qui relie électriquement ledit au moins un composant électronique (18a, 18b) avec ladite au moins une ligne d'énergie (8) ;
et
- ladite au moins une ligne d'énergie (8) étant disposée à distance dudit au moins un composant électronique (18a, 18b) ; et
- ladite au moins une ligne d'acheminement (7) étant disposée en angle par rapport à ladite au moins une ligne d'énergie (8).

2. Structure de couches textiles (100) selon la revendication 1, **caractérisée en ce que** la première couche textile (1) et/ou la deuxième couche textile (13) sont réalisées sous forme de couche textile non électroconductrice.

3. Structure de couches textiles (100) selon la revendication 1 ou 2, **caractérisée en ce que** le module électronique (18) comporte au moins un support intermédiaire (2), ledit au moins un composant électronique (18a, 18b) étant réalisé sur une première surface principale dudit au moins un support intermédiaire, et une deuxième surface principale, en regard de la première surface principale, dudit au moins un support intermédiaire comportant une interface commune avec une surface supérieure de la première couche textile (1) ou avec une surface inférieure de la deuxième couche textile (13).

4. Structure de couches textiles (100) selon l'une quelconque des revendications 1 à 3, **caractérisée en ce que** ledit au moins un composant électronique (18a, 18b) est réalisé sous la forme d'un circuit intégré.

5. Structure de couches textiles (100) selon l'une quelconque des revendications 1 à 4, **caractérisée en ce que** ledit au moins un composant électronique (18a, 18b) comporte au moins un élément d'émission et de réception.

6. Structure de couches textiles (100) selon l'une quelconque des revendications 1 à 5, **caractérisée en ce que** ladite au moins une ligne d'énergie (8) comporte au moins une couche textile de raccordement électroconductrice.

7. Structure de couches textiles (100) selon la revendication 6, **caractérisée en ce que** ladite au moins une couche textile de raccordement électroconductrice est réalisée de telle sorte qu'elle entoure une zone d'extrémité de la deuxième couche textile (13), réalisée dans ladite au moins une zone de lisière (40, 40a, 40b) de la structure de couches textiles (100).

8. Structure de couches textiles (100) selon la revendication 7, comportant au moins un rail de serrage (14) pour la mise en contact électrique de ladite au moins une couche textile de raccordement électroconductrice, lequel au moins un rail de serrage (14) entoure au moins une zone de lisière (40, 40a, 40b) de la structure de couches textiles (100).

9. Matrice de couches textiles, avec une pluralité de structures de couches textiles (100) selon l'une des revendications 1 à 8, lesquelles sont couplées entre elles par l'intermédiaire de ladite au moins une ligne d'énergie (8).

10. Procédé de fabrication d'une structure de couches textiles (100), dans lequel
- un module électronique (18) avec au moins un composant électronique (18a, 18b) est disposé sur une première couche textile (1) ;
- une deuxième couche textile (13) est formée sur la première couche textile (1) et sur ledit au moins un composant électronique (18a, 18b) ;
- au moins une structure électroconductrice réalisée sous la forme d'un élément capteur (10, 10a, 10b) est formée entre la première couche textile (1) et la deuxième couche textile (13), l'élément capteur (10, 10a, 10b) étant relié au module électronique (18) ;
- une couche électroconductrice (11) est formée, la première couche textile (1) étant formée sur la couche électroconductrice (11) ; ledit au moins un composant électronique (18a, 18b) étant couplé électriquement avec la couche électroconductrice (11) ; et
**caractérisé en ce que**
- au moins une ligne d'énergie (8), destinée à fournir l'énergie électrique, est formée dans au moins une zone de lisière (40, 40a, 40b) le long d'un bord (1c) de la structure de couches textiles (100) ;
- au moins une ligne d'acheminement (7) est formée à partir dudit au moins un composant électronique (18a, 18b) jusqu'à ladite au moins une zone de lisière (40, 40a, 40b) de la structure de couches textiles (100) ; et
- au moins une ligne d'énergie (8), formant un angle avec ladite au moins ladite une ligne d'acheminement (7) et située à distance dudit au moins un composant électronique (18a, 18b), est mise en contact électrique, par l'intermédiaire de ladite au moins une ligne d'acheminement (7), dans la zone de lisière (40, 40a, 40b) de la structure de couches textiles.

11. Procédé selon la revendication 10, **caractérisé en ce que** la première couche textile (1) et/ou la deuxième couche textile (13) sont réalisées sous forme de couche textile non électroconductrice.

12. Procédé selon la revendication 10 ou 11, **caractérisé en ce que** ledit au moins un composant électronique (18a, 18b) est couplé électriquement à la couche électroconductrice (11) par l'intermédiaire d'une métallisation électrique traversant la première couche textile (1).

13. Procédé selon la revendication 12, **caractérisé en ce que** la métallisation est effectuée moyennant l'utilisation d'un ou de plusieurs des procédés suivants :
- un procédé destiné à broder sur les filaments électroconducteurs ;
- un procédé de rivetage ;
- un procédé de sertissage.

14. Procédé selon l'une quelconque des revendications 10 à 13, **caractérisé en ce que** la première couche textile (1) et la deuxième couche textile (13) sont reliées l'une à l'autre moyennant un procédé de stratification.
